# EUROPEAN PATENT APPLICATION

(11) **EP 4 711 850 A1**
(43) Date of publication of application: **18.03.2026**
(21) Application number: 24803489.4
(22) Date of filing: 08.05.2024
(51) Int. Cl.: G03F 7/11, C08F 212/02, C08L 25/00, G03F 7/038, G03F 7/039, H01L 21/027

(54) **RESIST UNDERLAYER FILM-FORMING COMPOSITION**

(30) Priority: 09.05.2023 JP 2023077314
(71) Applicant: Nissan Chemical Corporation, Tokyo 103-6119 (JP)
(72) Inventor: MIZUOCHI, Ryuta, Toyama-shi, Toyama 939-2792 (JP); TAMURA, Mamoru, Toyama-shi, Toyama 939-2792 (JP)
(74) Representative: Müller-Boré & Partner Patentanwälte PartG mbB
(86) International application number: PCT/JP2024/017062
(87) International publication number: WO 2024/232380

(57) **Abstract**

The present invention relates to a resist underlayer film-forming composition for forming, in lithography using a photoresist film or an electron beam resist film, an underlayer film of the resist film on a nitrogen atom-containing substrate, the resist underlayer film-forming composition including: a polymer; and a crosslinking agent, the polymer having a structural unit (A) having a polycyclic aromatic structure.

## Description

### Technical Field

The present invention relates to a resist underlayer film-forming composition, an underlayer film, and a method for producing a semiconductor element.

### Background Art

With progress of a semiconductor manufacturing process and miniaturization of a large-scale integrated circuit (LSI), microfabrication is also performed in lithography using a resist composition. Specifically, the microfabrication is performed by using a processing method of forming microrelief corresponding to a photoresist pattern on a substrate surface by forming a thin film of a photoresist composition on a semiconductor substrate such as a silicon wafer, irradiating the thin film with an active ray such as an ultraviolet ray through a mask pattern on which a device pattern is drawn, developing the thin film, and etching the substrate using the obtained photoresist pattern as a protective film, or the like.

To further improve the accuracy of the microfabrication using such a resist composition, it is required to improve the quality and characteristics of the resist underlayer film. For example, in a case where a substrate on which a resist underlayer film is formed or a film of the substrate contains nitrogen atoms, amine components may diffuse from the substrate, and the resolution of the resist may decrease (Patent Literatures 1 to 3).

### Citation List

### Patent Literature

Patent Literature 1: JP 2008-39811 A
Patent Literature 2: JP 2008-39815 A
Patent Literature 3: JP 2010-134437 A

### Summary of Invention

### Technical Problem

The present invention provides a composition for forming a resist underlayer film, which can form a photoresist pattern with high accuracy even when a substrate containing a nitrogen atom is used, and which can be used as an antireflection film at the time of exposure. Furthermore, the present invention provides a composition capable of suppressing a decrease in accuracy of a photoresist pattern due to diffusion of amine components derived from a substrate during a certain period, even after the certain period of, for example, several days or more, has elapsed following formation of the resist underlayer film formed with the composition of the present invention on the substrate, until the pattern formation is carried out.

### Solution to Problem

As a result of intensive studies to solve the above problem, the present inventors have found that the above problem can be solved and have completed the present invention having the following gist.

That is, the present invention includes the following aspects.
[1] A resist underlayer film-forming composition for forming, in lithography using a photoresist film or an electron beam resist film, an underlayer film of the resist film on a nitrogen atom-containing substrate,
   the resist underlayer film-forming composition including:
   a polymer; and a crosslinking agent,
   the polymer having a structural unit (A) having a polycyclic aromatic structure.
[2] The resist underlayer film-forming composition according to [1], wherein the polymer has the polycyclic aromatic structure in a side chain of the polymer.
[3] The resist underlayer film-forming composition according to [1] or [2], wherein the polycyclic aromatic structure is selected from naphthalene, anthracene, phenanthrene, pyrene, triphenylene, chrysene, naphthacene, biphenylene, fluorene, and carbazole, and may be substituted.
[4] The resist underlayer film-forming composition according to any one of [1] to [3], wherein the unit structure (A) is a unit structure represented by formula (A-1) below: 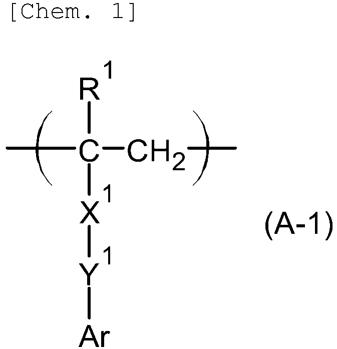 in formula (A-1), R¹ represents a hydrogen atom or a methyl group, X¹ represents a single bond, an ester group, or an amide group, Y¹ represents a single bond or an alkylene group having 1 to 6 carbon atoms, and Ar represents a monovalent group that is obtained by removing a hydrogen atom from naphthalene, anthracene, phenanthrene, pyrene, triphenylene, chrysene, naphthacene, biphenylene, fluorene, or carbazole and may be substituted.
[5] The resist underlayer film-forming composition according to any one of [1] to [4], wherein
   the polymer further has a unit structure (B) having a reactive group, and
   the crosslinking agent has a functional group capable of reacting with the reactive group.
[6] The resist underlayer film-forming composition according to [5], wherein the unit structure (B) is at least one of a unit structure represented by formula (B-1) below and a unit structure represented by formula (B-2) below: 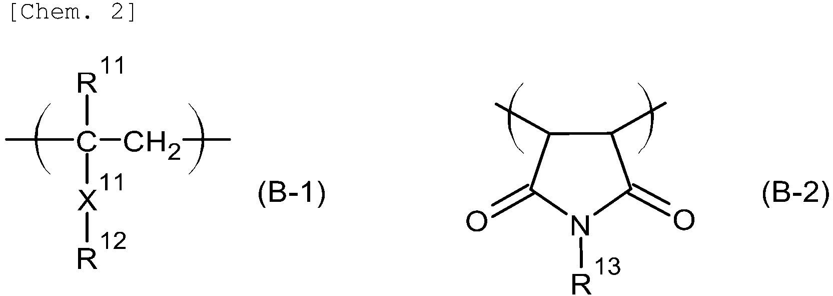
   in formula (B-1), R¹¹ represents a hydrogen atom or a methyl group, X¹¹ represents an ester group or an amide group, and R¹² represents a monovalent group having 1 to 12 carbon atoms and having the reactive group, and
   in formula (B-2), R¹³ represents a monovalent group having 1 to 12 carbon atoms and having the reactive group.
[7] The resist underlayer film-forming composition according to any one of [1] to [6], wherein the polymer further has a unit structure (C) of at least one of a unit structure (C-1) having a monocyclic aromatic structure and a unit structure (C-2) derived from a maleimide structure.
[8] The resist underlayer film-forming composition according to [7], wherein
   the unit structure (C-1) is a unit structure represented by formula (C-1-1) below, and
   the unit structure (C-2) is a unit structure represented by formula (C-2-1) below: 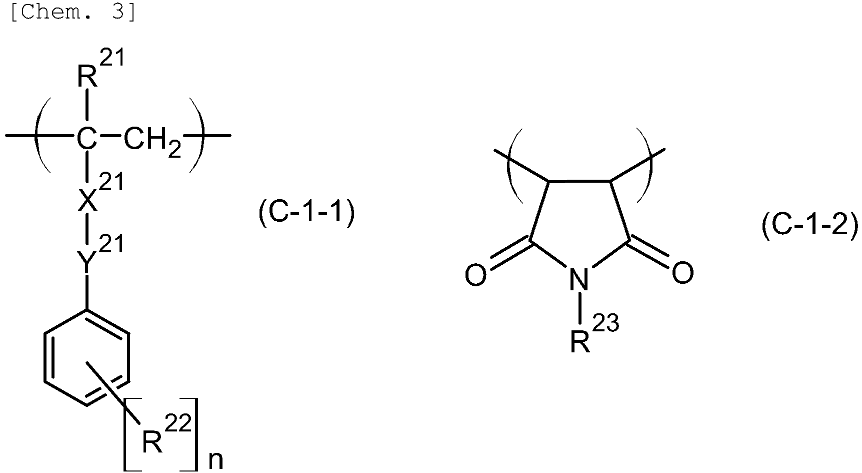
   in formula (C-1-1), R²¹ represents a hydrogen atom or a methyl group, X²¹ represents a single bond, an ester group, or an amide group, Y²¹ represents a single bond or an alkylene group having 1 to 6 carbon atoms, R²² represents a halogen atom, an alkyl group that has 1 to 6 carbon atoms and may be substituted with a halogen atom, or an alkoxy group that has 1 to 6 carbon atoms and may be substituted with a halogen atom, n represents an integer of 0 to 5, and when there are two or more R²²'s, the two or more R²²'s may be identical or different, and
   in formula (C-1-2), R²³ represents a hydrogen atom, an alkyl group that has 1 to 10 carbon atoms and may be substituted with a halogen atom, or an aryl group that has 6 to 10 carbon atoms and may be substituted with a halogen atom.
[9] The resist underlayer film-forming composition according to any one of [1] to [8], wherein a molar ratio of the unit structure (A) to all unit structures of the polymer is 40 mol% or more.
[10] The resist underlayer film-forming composition according to any one of [5] to [9], wherein a molar ratio of the unit structure (B) to all unit structures of the polymer is 5 mol% to 40 mol%.
[11] The resist underlayer film-forming composition according to any one of [1] to [10], wherein
   the polymer further has a unit structure (B) having a reactive group, and a unit structure (C) of at least one of a unit structure (C-1) having a monocyclic aromatic structure and a unit structure (C-2) derived from a maleimide structure,
   the crosslinking agent has a functional group capable of reacting with the reactive group,
   the unit structure (A) is a unit structure represented by formula (A-1) below,
   the unit structure (B) is at least one of a unit structure represented by formula (B-1) below and a unit structure represented by formula (B-2) below,
   the unit structure (C-1) is a unit structure represented by formula (C-1-1) below,
   the unit structure (C-2) is a unit structure represented by formula (C-2-1) below,
   a molar ratio of the unit structure (A) to all unit structures of the polymer is 40 mol% or more, and
   a molar ratio of the unit structure (B) to all unit structures of the polymer is 5 mol% to 40 mol%: 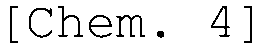 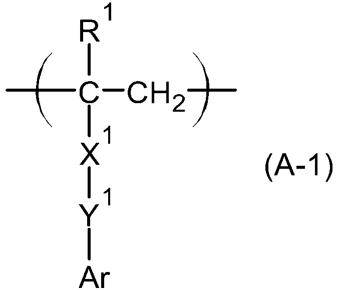
   in formula (A-1), R¹ represents a hydrogen atom or a methyl group, X¹ represents a single bond, an ester group, or an amide group, Y¹ represents a single bond or an alkylene group having 1 to 6 carbon atoms, and Ar represents a monovalent group that is obtained by removing a hydrogen atom from naphthalene, anthracene, phenanthrene, pyrene, triphenylene, chrysene, naphthacene, biphenylene, fluorene, or carbazole and may be substituted, 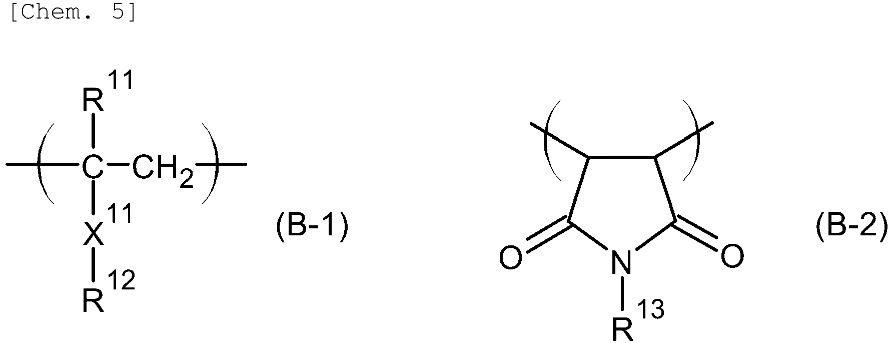
   in formula (B-1), R¹¹ represents a hydrogen atom or a methyl group, X¹¹ represents an ester group or an amide group, and R¹² represents a monovalent group having 1 to 6 carbon atoms and having the reactive group, and
   in formula (B-2), R¹³ represents a monovalent group having 1 to 6 carbon atoms and having the reactive group, 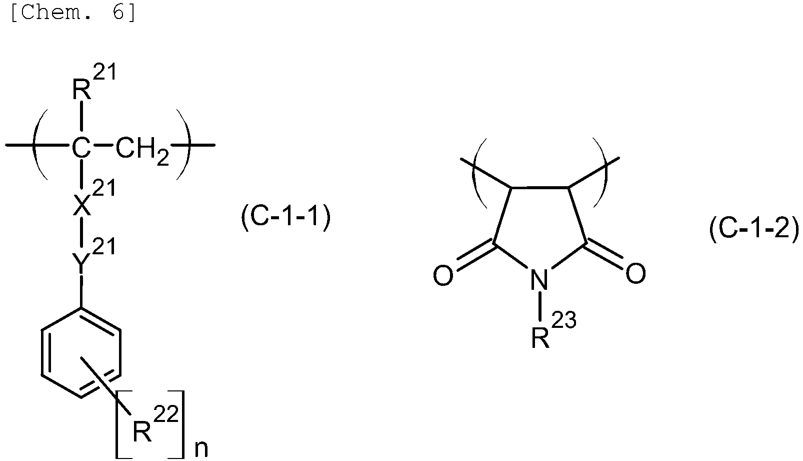
   in formula (C-1-1), R²¹ represents a hydrogen atom or a methyl group, X²¹ represents a single bond, an ester group, or an amide group, Y²¹ represents a single bond or an alkylene group having 1 to 6 carbon atoms, R²² represents a halogen atom, an alkyl group that has 1 to 6 carbon atoms and may be substituted with a halogen atom, or an alkoxy group that has 1 to 6 carbon atoms and may be substituted with a halogen atom, n represents an integer of 0 to 5, and when there are two or more R²²'s, the two or more R²²'s may be identical or different, and
   in formula (C-1-2), R²³ represents a hydrogen atom, an alkyl group that has 1 to 10 carbon atoms and may be substituted with a halogen atom, or an aryl group that has 6 to 10 carbon atoms and may be substituted with a halogen atom.
[12] The resist underlayer film-forming composition according to any one of [1] to [11], wherein a content of the crosslinking agent is 20 mass% to 50 mass% of the polymer.
[13] An underlayer film formed on the nitrogen atom-containing substrate by using the resist underlayer film-forming composition according to any one of [1] to [12].
[14] The underlayer film according to [13], wherein a film thickness is less than 10 nm.
[15] A method for producing a resist-patterned substrate, the method including steps of:
   forming an underlayer film on the nitrogen atom-containing substrate using the resist underlayer film-forming composition according to any one of [1] to [12];
   forming a resist film of either a photoresist film or an electron beam resist film on the underlayer film; and
   irradiating the resist film with light or an electron beam, and then developing the resist film to obtain a resist pattern.
[16] The method for producing a resist-patterned substrate according to [15], the method including a step of forming the resist film after 12 hours or more has elapsed following formation of the underlayer film.
[17] A method for producing a semiconductor element, the method including steps of:
   forming an underlayer film on the nitrogen atom-containing substrate using the resist underlayer film-forming composition according to any one of [1] to [12];
   forming a resist film of either a photoresist film or an electron beam resist film on the underlayer film;
   irradiating the resist film with light or an electron beam, and then developing the resist film to obtain a resist pattern; and
   forming a patterned underlayer film by etching the underlayer film using the resist pattern as a mask.

### Advantageous Effects of Invention

According to the present invention, it is possible to form a resist underlayer film capable of suppressing a decrease in resist resolution due to diffusion of amine components. In addition, according to the present invention, it is possible to form a resist underlayer film in which the resolution is less likely to decrease even after a predetermined period has elapsed following formation of the resist underlayer film on the substrate, until the pattern formation is carried out.

### Description of Embodiments

### (Resist Underlayer Film-Forming Composition)

The resist underlayer film-forming composition of the present invention is used to form an underlayer film of the resist film on a nitrogen atom-containing substrate in lithography using a photoresist film or an electron beam resist film.

The resist underlayer film-forming composition of the present invention includes a polymer and a crosslinking agent.

The polymer has a unit structure (A) having a polycyclic aromatic structure.

When the resist underlayer film-forming composition contains a polymer and a crosslinking agent, and the polymer has the unit structure (A) having a polycyclic aromatic structure, a resist underlayer film capable of suppressing a decrease in resist resolution can be formed. In addition, it is possible to form a resist underlayer film in which the resolution is less likely to decrease even after a predetermined period has elapsed following formation of the resist underlayer film.

The predetermined period is, for example, 12 hours or more, 24 hours or more, 48 hours or more, 72 hours or more, or 92 hours or more. The storage temperature is, for example, 20°C to 30°C, and the storage humidity is, for example, 30 to 70%RH, 30 to 60%RH, or 35 to 55%RH.

### <Polymer>

The polymer has a unit structure (A) having a polycyclic aromatic structure. The polymer preferably has a polycyclic aromatic structure in a side chain.

The polymer preferably has a unit structure (B) having a reactive group. The crosslinking agent preferably has a reaction group capable of reacting with the reactive group. Hereinafter, this polymer is sometimes referred to as a "specific polymer".

### <<Unit structure (A)>>

The unit structure (A) is a unit structure having a polycyclic aromatic structure.

In the present description, the polycyclic aromatic structure is a structure formed of two or more aromatic rings exhibiting aromaticity, and includes a fused polycyclic aromatic structure having a fused ring and an aromatic ring assembly structure in which a plurality of aromatic rings are directly bonded through a single bond.

The polycyclic aromatic structure may be a structure formed only of a hydrocarbon or a structure having a hetero atom (for example, an oxygen atom, a nitrogen atom, or a sulfur atom).

The fused polycyclic aromatic structure is not particularly limited, and examples thereof include a naphthalene structure, an anthracene structure, a phenanthrene structure, a pyrene structure, a triphenylene structure, a chrysene structure, a naphthacene structure, a biphenylene structure, and a fluorene structure.

The aromatic ring assembly structure is not particularly limited, and examples thereof include a carbazole structure, a biphenyl structure, a terphenyl structure, a quaterphenyl structure, a binaphthalene structure, a phenylnaphthalene structure, a phenylfluorene structure, and a diphenylfluorene structure.

The polycyclic aromatic structure is preferably selected from naphthalene, anthracene, phenanthrene, pyrene, triphenylene, chrysene, naphthacene, biphenylene, fluorene, or carbazole and may be substituted.

The polycyclic aromatic structure (fused polycyclic aromatic structure, aromatic ring assembly structure) may be substituted with a substituent. The substituent which may be substituted is not particularly limited, and examples thereof include a halogen atom, a hydroxy group, an alkyl group, an alkoxy group, a thiol group, a cyano group, a carboxyl group, an amino group, an amide group, an alkoxycarbonyl group, and a thioalkyl group.

Examples of the halogen atom include a fluorine atom, a chlorine atom, a bromine atom, and an iodine atom.

Examples of the alkyl group include an alkyl group having 1 to 6 carbon atoms. Examples of the alkyl group having 1 to 6 carbon atoms include a methyl group, an ethyl group, an n-propyl group, an i-propyl group, an n-butyl group, an i-butyl group, an s-butyl group, a t-butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group. Further, a cyclic alkyl group can also be used as the alkyl group, and examples of a cyclic alkyl group having 1 to 10 carbon atoms include a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group.

Examples of the alkoxy group include an alkoxy group having 1 to 6 carbon atoms. Examples of the alkoxy group having 1 to 6 carbon atoms include a methoxy group, an ethoxy group, and an isopropoxy group.

Examples of the amide group include an amide group having 1 to 12 carbon atoms. Examples of the amide group having 1 to 12 carbon atoms include a formamide group, an acetamide group, a propionamide group, an isobutyramide group, a benzamide group, a naphthylamide group, and an acrylamide group.

Examples of the alkoxycarbonyl group include an alkoxycarbonyl group having 2 to 12 carbon atoms. Examples of the alkoxycarbonyl group having 2 to 12 carbon atoms include a methoxycarbonyl group, an ethoxycarbonyl group, and a benzyloxycarbonyl group.

Examples of the thioalkyl group include a thioalkyl group having 1 to 6 carbon atoms. Examples of the thioalkyl group having 1 to 6 carbon atoms include a methylthio group, an ethylthio group, a butylthio group, and a hexylthio group.

From the viewpoint of suitably obtaining the effect of the present invention, the polycyclic aromatic structure is preferably a naphthalene structure, an anthracene structure, a phenanthrene structure, a pyrene structure, a triphenylene structure, a chrysene structure, a naphthacene structure, a biphenylene structure, a fluorene structure, or a carbazole structure, more preferably a naphthalene structure, an anthracene structure, a phenanthrene structure, a pyrene structure, or a carbazole structure, and still more preferably a naphthalene structure or a carbazole structure.

The polycyclic aromatic structure may be of one type or two or more types, but is preferably of one type or two types.

The unit structure (A) is not particularly limited, but a unit structure represented by formula (A-1) below is preferable from the viewpoint of suitably obtaining the effect of the present invention.

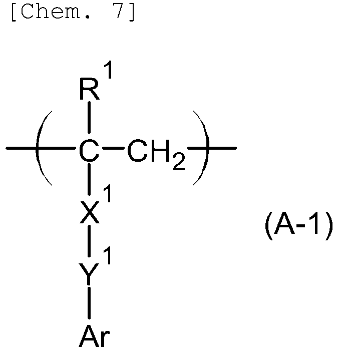

In formula (A-1), R¹ represents a hydrogen atom or a methyl group, X¹ represents a single bond, an ester group, or an amide group, Y¹ represents a single bond or an alkylene group having 1 to 6 carbon atoms, and Ar represents a monovalent group that is obtained by removing a hydrogen atom from naphthalene, anthracene, phenanthrene, pyrene, triphenylene, chrysene, naphthacene, biphenylene, fluorene, or carbazole and may be substituted,

The unit structure represented by the formula (A-1) includes vinylnaphthalene having naphthalene as Ar in a side chain, and the like.

Examples of the substituent that Ar may have include a halogen atom, a hydroxy group, an alkyl group, an alkoxy group, a thiol group, a cyano group, a carboxyl group, an amino group, an amide group, an alkoxycarbonyl group, and a thioalkyl group.

The unit structure represented by formula (A-1) is not particularly limited, but a unit structure represented by formula (A-1-1) below is preferable from the viewpoint of suitably obtaining the effect of the present invention.

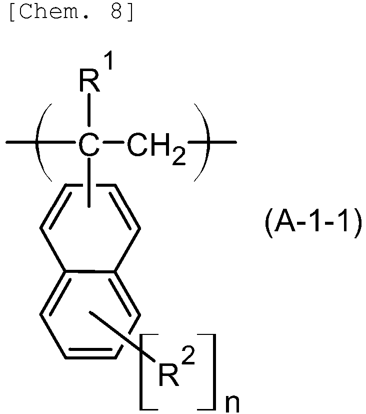

In formula (A-1-1), R¹ represents a hydrogen atom or a methyl group, R² represents a halogen atom, a hydroxy group, an alkyl group, an alkoxy group, a thiol group, a cyano group, a carboxyl group, an amino group, an amide group, an alkoxycarbonyl group, or a thioalkyl group, n represents an integer of 0 to 7, and when there are two or more R²'s, the two or more R²'s may be identical or different.

Examples of the unit structure represented by formula (A-1) include the following unit structures.

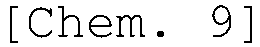

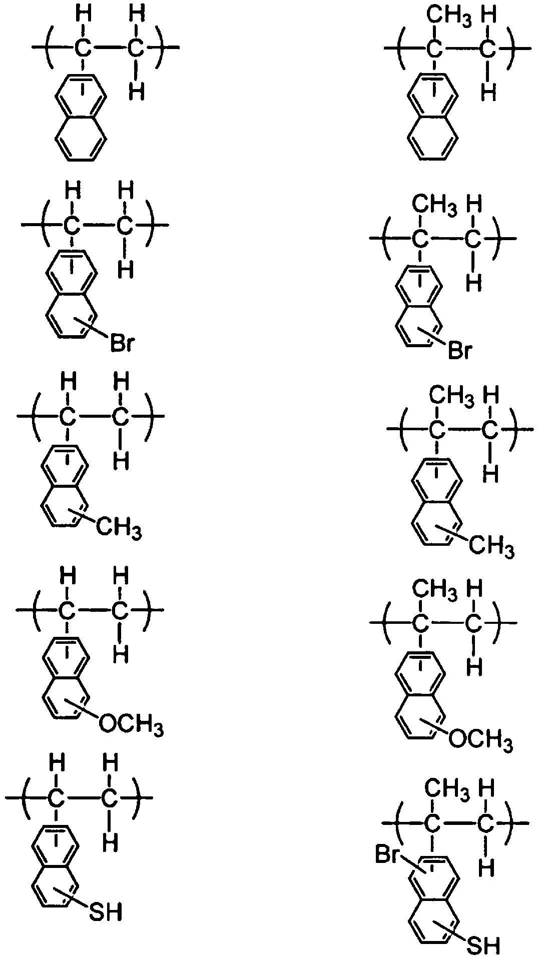

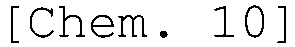

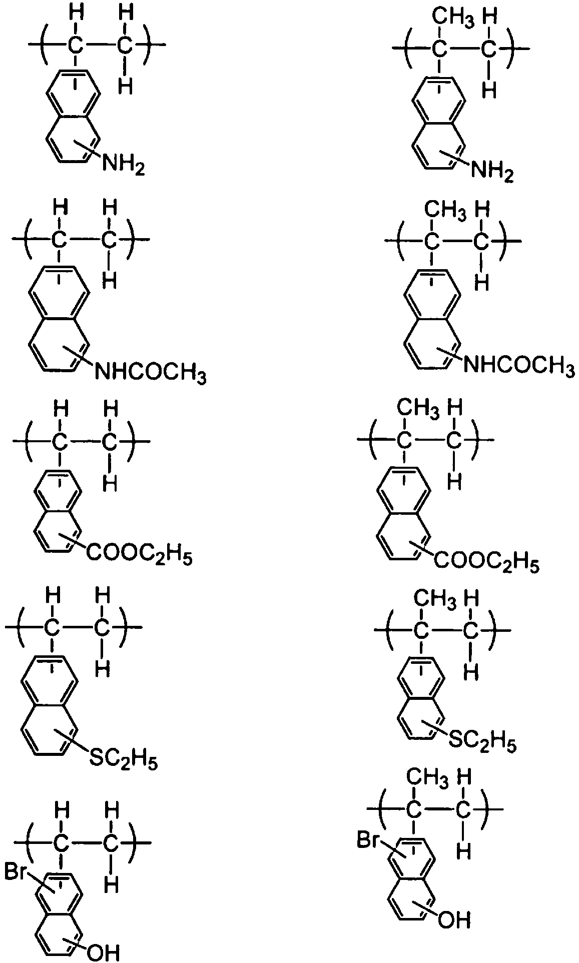

The unit structure (A) in the specific polymer may be of one type or two or more types, but is preferably of one type or two types.

### <<Unit structure (B)>>

The unit structure (B) is a unit structure having a reactive group.

The unit structure (B) is a structure different from the unit structure (A). For example, the unit structure (B) does not have a polycyclic aromatic structure.

The reactive group of the unit structure (B) is not particularly limited, and examples thereof include a hydroxy group, an epoxy group, an acyl group, an acetyl group, a formyl group, a benzoyl group, a carboxyl group, a carbonyl group, an amino group, an imino group, a cyano group, an azo group, an azide group, a thiol group, a sulfo group, and an allyl group.

The unit structure (B) is not particularly limited, and is preferably at least either of a unit structure represented by formula (B-1) below and a unit structure represented by formula (B-2) below from the viewpoint of suitably obtaining the effect of the present invention.

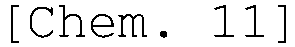

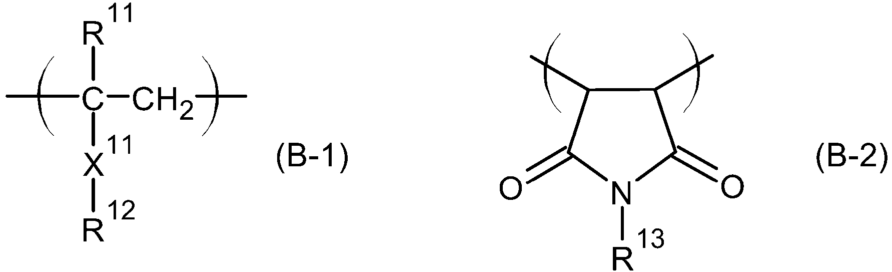

In formula (B-1), R¹¹ represents a hydrogen atom or a methyl group, X¹¹ represents an ester group or an amide group, and R¹² represents a monovalent group having 1 to 12 carbon atoms and having a reactive group, and
in formula (B-2), R¹³ represents a monovalent group having 1 to 12 carbon atoms and having a reactive group.

Examples of the monovalent group having 1 to 12 carbon atoms and having a reactive group in R¹² and R¹³ include a hydroxyalkyl group having 1 to 12 carbon atoms.

Examples of the hydroxyalkyl group having 1 to 12 carbon atoms include a hydroxyalkyl group having 1 to 6 carbon atoms.

Examples of the hydroxyalkyl group having 1 to 12 carbon atoms include a hydroxymethyl group, a 1-hydroxyethyl group, a 2-hydroxyethyl group, a 1-hydroxypropyl group, a 2-hydroxypropyl group, a 3-hydroxypropyl group, a 1-hydroxybutyl group, a 2-hydroxybutyl group, a 3-hydroxybutyl group, a 4-hydroxybutyl group, a hydroxycyclohexyl group, a dihydroxycyclohexyl group, and a 3-hydroxy-1-adamantyl group.

The number of hydroxy groups of the hydroxyalkyl group having 1 to 12 carbon atoms may be 1 or 2 or more.

Examples of the unit structure represented by formula (B-1) include a unit structure represented by formula (B-1-1) below.

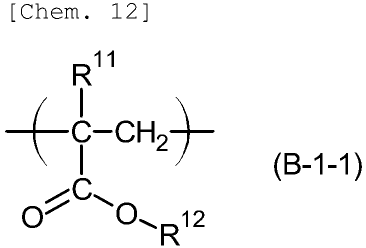

In formula (B-1-1), R¹¹ and R¹² have the same meanings as R¹¹ and R¹² in formula (B-1), respectively.

Examples of the unit structure represented by formula (B-1) include the following unit structures.

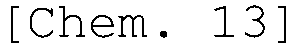

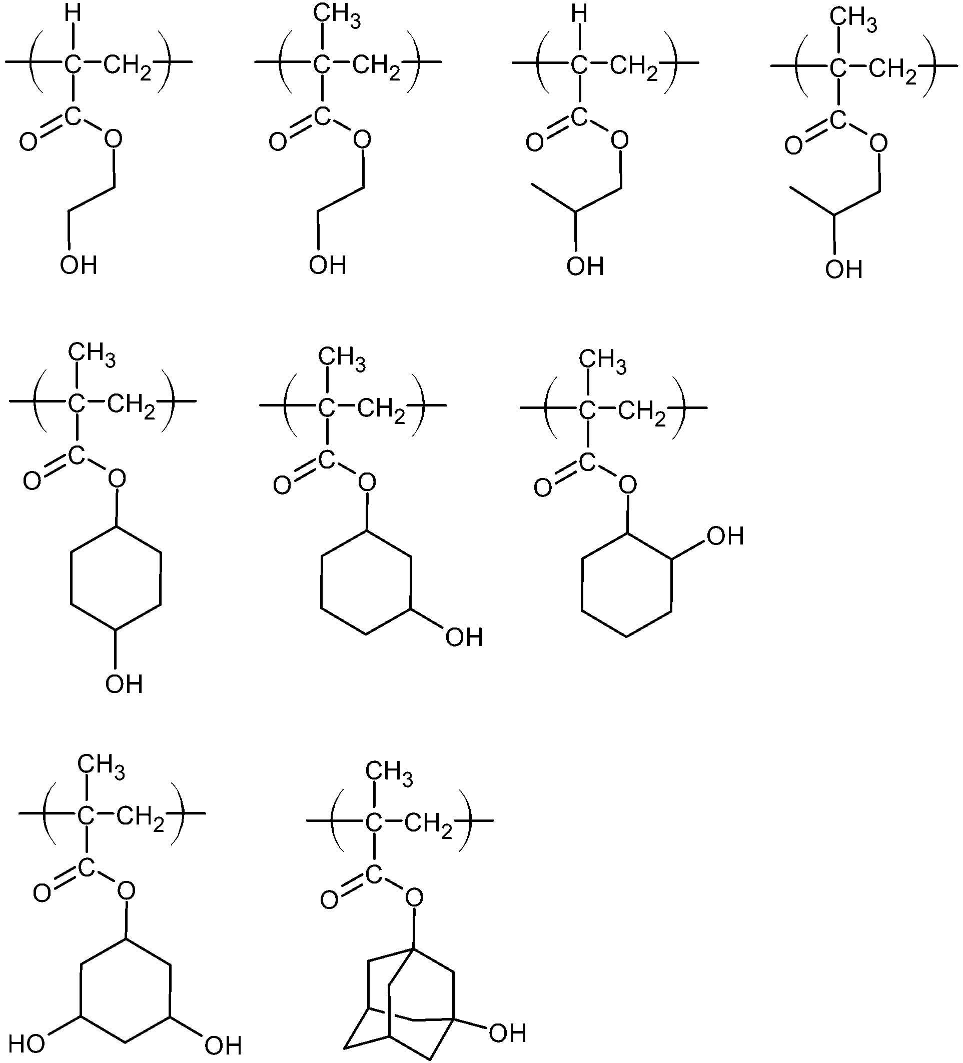

Examples of the unit structure represented by formula (B-2) include the following unit structures.

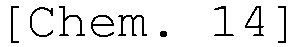

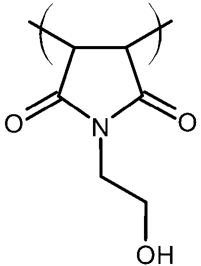

Examples of the unit structure containing an epoxy group as the reactive group include unit structures derived from compounds represented by general formulae (I) to (XVII) described in JP 2012-62365 A.

The unit structure (B) in the specific polymer may be of one type or two or more types, but is preferably of one type or two types.

### <<Unit Structure (C)>>

The specific polymer may have a unit structure other than the unit structure (A) and the unit structure (B). As such a unit structure, from the viewpoint of suitably obtaining the effect of the present invention, a unit structure (C) of at least either of a unit structure (C-1) having a monocyclic aromatic structure and a unit structure (C-2) derived from a maleimide structure is preferable.

The unit structure (C) is a unit structure different from the unit structure (A) and the unit structure (B).

For example, the unit structure (C) does not have a polycyclic aromatic structure and the reactive group of the unit structure (B).

The monocyclic aromatic ring of the unit structure (C-1) may be an aromatic hydrocarbon ring or an aromatic heterocyclic ring, but is preferably an aromatic hydrocarbon ring. Examples of such an aromatic hydrocarbon ring include a benzene ring.

The unit structure (C) is not particularly limited, and is preferably at least either of a unit structure (C-1) represented by formula (C-1-1) below and a unit structure (C-2) represented by formula (C-1-2) below from the viewpoint of suitably obtaining the effect of the present invention.

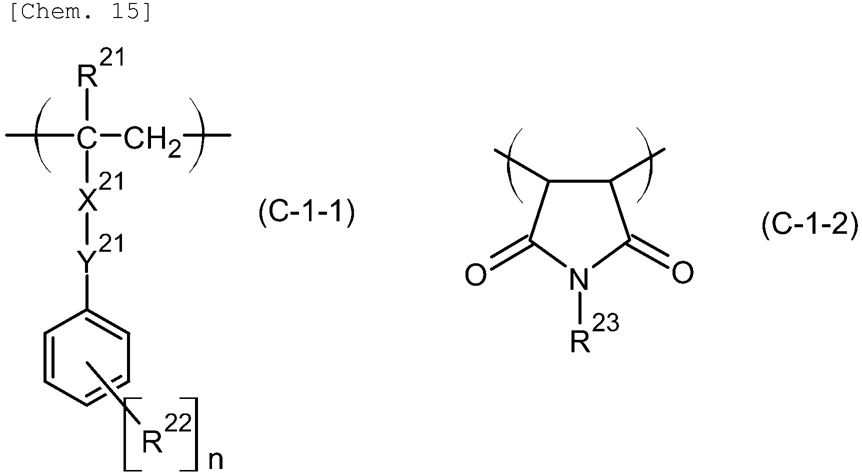

In formula (C-1-1), R²¹ represents a hydrogen atom or a methyl group, X²¹ represents a single bond, an ester group, or an amide group, Y²¹ represents a single bond or an alkylene group having 1 to 6 carbon atoms, R²² represents a halogen atom, an alkyl group that has 1 to 6 carbon atoms and may be substituted with a halogen atom, or an alkoxy group that has 1 to 6 carbon atoms and may be substituted with a halogen atom, n represents an integer of 0 to 5, and when there are two or more R²²'s, the two or more R²²'s may be identical or different, and
in formula (C-1-2), R²³ represents a hydrogen atom, an alkyl group that has 1 to 10 carbon atoms and may be substituted with a halogen atom, or an aryl group that has 6 to 10 carbon atoms and may be substituted with a halogen atom.

Examples of the unit structure represented by formula (C-1-1) include a unit structure represented by formula (C-1-1-1) below and a unit structure represented by formula (C-1-1-2) below.

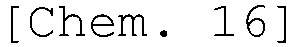

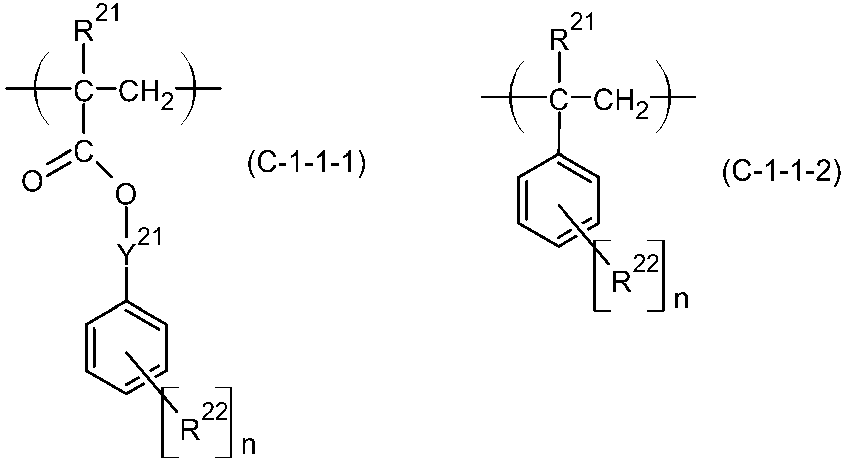

In formulae (C-1-1-1) and (C-1-1-2), R²¹ represents a hydrogen atom or a methyl group, Y²¹ represents a single bond or an alkylene group having 1 to 6 carbon atoms, R²² represents a halogen atom, an alkyl group that has 1 to 6 carbon atoms and may be substituted with a halogen atom, or an alkoxy group that has 1 to 6 carbon atoms and may be substituted with a halogen atom, n represents an integer of 0 to 5, and when there are two or more R²²'s, the two or more R²²'s may be identical or different.

In formula (C-1-1-2), n is preferably an integer of 1 to 5.

Examples of the unit structure represented by formula (C-1-1) include the following unit structures.

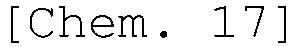

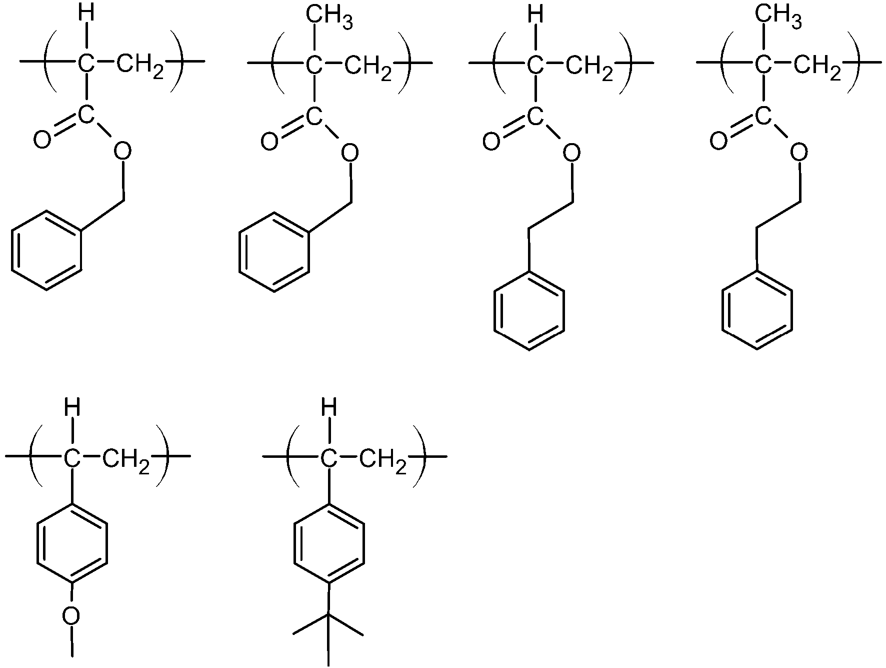

Examples of the unit structure represented by formula (C-1-2) include the following unit structures.

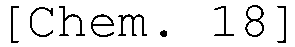

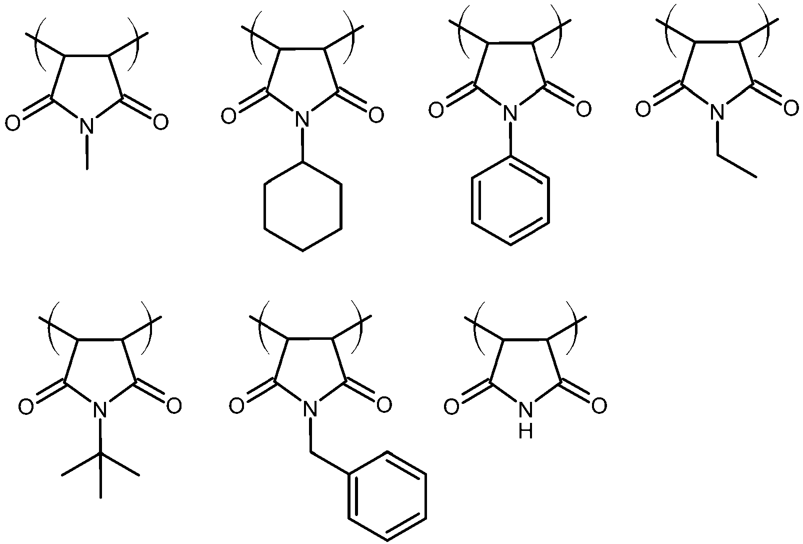

The unit structure (C) in the specific polymer may be of one type or two or more types, but is preferably of one type or two types.

The molar ratio of the unit structure (A) to all unit structures of the specific polymer is not particularly limited, and is preferably 40 mol% or more, more preferably 45 mol% or more, and particularly preferably 50 mol% or more from the viewpoint of suitably obtaining the effect of the present invention.

The molar ratio of the unit structure (A) to all unit structures of the specific polymer is preferably 95 mol% or less, more preferably 90 mol% or less, and particularly preferably 80 mol% or less.

When the specific polymer has the unit structure (B), the molar ratio of the unit structure (B) to all unit structures of the specific polymer is not particularly limited, and is preferably 5 mol% or more, more preferably 10 mol% or more, and particularly preferably 15 mol% or more from the viewpoint of suitably obtaining the effect of the present invention.

The molar ratio of the unit structure (B) to all unit structures of the specific polymer is preferably 40 mol% or less, more preferably 35 mol% or less, and particularly preferably 30 mol% or less.

When the specific polymer has the unit structure (C), the molar ratio of the unit structure (C) to all unit structures of the specific polymer is not particularly limited, and is preferably 5 mol% or more, more preferably 10 mol% or more, and particularly preferably 15 mol% or more from the viewpoint of suitably obtaining the effect of the present invention.

The molar ratio of the unit structure (C) to all unit structures of the specific polymer is preferably 40 mol% or less, more preferably 35 mol% or less, and particularly preferably 30 mol% or less.

The molar ratio of the unit structure (A) to the unit structure (B) (unit structure (A)/unit structure (B)) in the specific polymer is not particularly limited, and is preferably 1 to 9, and more preferably 1.5 to 5.

The distribution of the unit structure in the specific polymer is not particularly limited. The specific polymer may be a block copolymer or a random copolymer.

The molecular weight of the specific polymer is not particularly limited, and the weight average molecular weight measured by gel permeation chromatography (hereinafter, sometimes abbreviated as GPC) is preferably 1,500 to 100,000 and more preferably 2,000 to 50,000.

### <<Method for producing specific polymer>>

The method for producing the specific polymer is not particularly limited, and for example, the specific polymer of the present embodiment can be obtained by causing a reaction of a carbon-carbon double bond of a monomer that provides the unit structure (A), a carbon-carbon double bond of a monomer that provides the unit structure (B), and a carbon-carbon double bond of a monomer that provides an arbitrary unit structure (C).

As a polymerization method for the specific polymer, a known polymerization method such as radical polymerization, anionic polymerization, or cationic polymerization can be used. Various known techniques such as solution polymerization, suspension polymerization, emulsion polymerization, and bulk polymerization can be used.

The polymerization initiator used in the polymerization is not particularly limited, and examples thereof include 2,2'-azobis(isobutyronitrile), 2,2'-azobis(2-methylbutyronitrile), 2,2'-azobis(2,4-dimethylvaleronitrile), 4,4'-azobis(4-cyanovaleric acid), 2,2'-azobis(2,4-dimethylvaleronitrile), 2,2'-azobis(4-methoxy-2,4-dimethylvaleronitrile), 2,2'-azobis(isobutyronitrile), 1,1'-azobis(cyclohexane-1-carbonitrile), 1-[(1-cyano-1-methylethyl)azo]formamide, 2,2'-azobis[2-(2-imidazolin-2-yl)propane]dihydrochloride, 2,2'-azobis[2-(2-imidazolin-2-yl)propane], and 2,2'-azobis(2-methylpropionamidine)dihydrochloride.

The solvent used in the polymerization is not particularly limited, and for example, dioxane, ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monomethyl ether, propylene glycol monomethyl ether acetate, propylene glycol propyl ether acetate, toluene, xylene, methyl ethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, or the like can be used. These solvents may be used alone or in admixture.

The reaction temperature is not particularly limited, and is, for example, 20°C to 150°C.

The reaction time is not particularly limited, and is, for example, 1 hour to 72 hours.

A solution containing the obtained polymer can also be used as it is for the preparation of the resist underlayer film-forming composition. The polymer can also be used by being isolated by precipitation in a poor solvent such as methanol, ethanol, isopropanol, or water, or a mixed solvent thereof and recovered.

The content of the specific polymer in the resist underlayer film-forming composition is not particularly limited, but is preferably 0.1 mass% to 50 mass%, and more preferably 0.1 mass% to 10 mass% with respect to the entire resist underlayer film-forming composition from the viewpoint of solubility.

Further, the content of the specific polymer in the resist underlayer film-forming composition is preferably 50 mass% to 95 mass%, more preferably 55 mass% to 90 mass%, and particularly preferably 60 mass% to 85 mass% with respect to the film constituent components.

The film constituent components mean components other than the solvent contained in the composition.

### <Crosslinking Agent>

The resist underlayer film-forming composition contains a crosslinking agent.

The crosslinking agent preferably has a functional group capable of reacting with the reactive group of the unit structure (B).

The number of functional groups in the crosslinking agent is not particularly limited, and may be one or two or more.

The functional group capable of reacting with the reactive group of the unit structure (B) is not particularly limited, and examples thereof include a hydroxy group, an epoxy group, an acyl group, an acetyl group, a formyl group, a benzoyl group, a carboxyl group, a carbonyl group, an amino group, an imino group, a cyano group, an azo group, an azide group, a thiol group, a sulfo group, an allyl group, and a structure represented by formula (D) below.

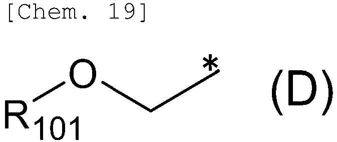

In formula (D), R₁₀₁ represents a hydrogen atom, an alkyl group having 1 to 4 carbon atoms, or an alkoxyalkyl group having 2 to 6 carbon atoms, and * represents a bond.

The bond is bonded to, for example, a nitrogen atom, a carbon atom constituting an aromatic hydrocarbon ring, or the like.

When the reactive group of the unit structure (B) is a hydroxy group or a thiol group, examples of the functional group capable of reacting with the reactive group of the unit structure (B) include a structure represented by formula (D).

When the reactive group of the unit structure (B) is an epoxy group, examples of the functional group capable of reacting with the reactive group of the unit structure (B) include a carboxyl group, an amino group, and a thiol group.

Examples of the crosslinking agent include a compound having two or more structures represented by formula (D) above.

As R₁₀₁, a hydrogen atom, a methyl group, an ethyl group, or a group represented by the following structure is preferred.

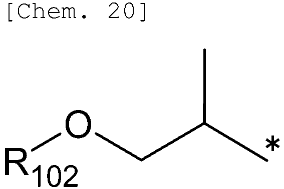

In the structure, R₁₀₂ represents a hydrogen atom, a methyl group, or an ethyl group, and * represents a bond.

The crosslinking agent is preferably a melamine compound, a guanamine compound, a glycoluril compound, a urea compound, or a compound having a phenolic hydroxy group. One type of these can be used alone or two or more types thereof can be used in combination.

The melamine compound is not particularly limited as long as it is a melamine compound having a group that can react with the reactive group (for example, a hydroxy group) of the unit structure (B).

Examples of the melamine compound include hexamethylolmelamine, hexamethoxymethylmelamine, a compound in which 1 to 6 methylol groups of hexamethylolmelamine are methoxymethylated or a mixture thereof, hexamethoxyethylmelamine, hexaacyloxymethylmelamine, and a compound in which 1 to 6 methylol groups of hexamethylolmelamine are acyloxymethylated or a mixture thereof.

The guanamine compound is not particularly limited as long as it is a guanamine compound having a group that can react with the reactive group (for example, a hydroxy group) of the unit structure (B).

Examples of the guanamine compound include tetramethylolguanamine, tetramethoxymethylguanamine, a compound in which 1 to 4 methylol groups of tetramethylolguanamine are methoxymethylated or a mixture thereof, tetramethoxyethylguanamine, tetraacyloxyguanamine, and a compound in which 1 to 4 methylol groups of tetramethylolguanamine are acyloxymethylated or a mixture thereof.

The glycoluril compound is not particularly limited as long as it is a glycoluril compound having a group that can react with the reactive group (for example, a hydroxy group) of the unit structure (B).

Examples of the glycoluril compound include tetramethylolglycoluril, tetramethoxyglycoluril, tetramethoxymethylglycoluril, a compound in which 1 to 4 methylol groups of tetramethylolglycoluril are methoxymethylated or a mixture thereof, and a compound in which 1 to 4 methylol groups of tetramethylolglycoluril are acyloxymethylated or a mixture thereof.

The glycoluril compound may be, for example, a glycoluril derivative represented by formula (1E) below.

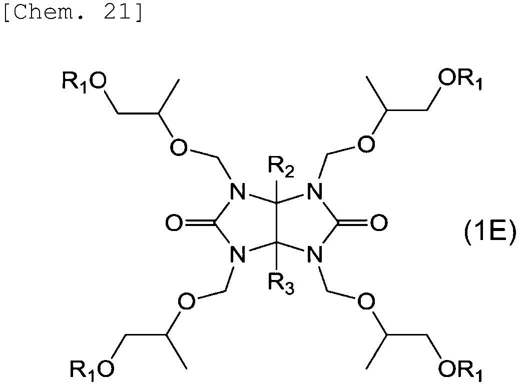

In formula (1E), four R₁'s each independently represent a methyl group or an ethyl group, and R₂ and R₃ each independently represent a hydrogen atom, an alkyl group having 1 to 4 carbon atoms, or a phenyl group.

Examples of the glycoluril derivative represented by formula (1E) include compounds represented by formulae (1E-1) to (1E-6) below.

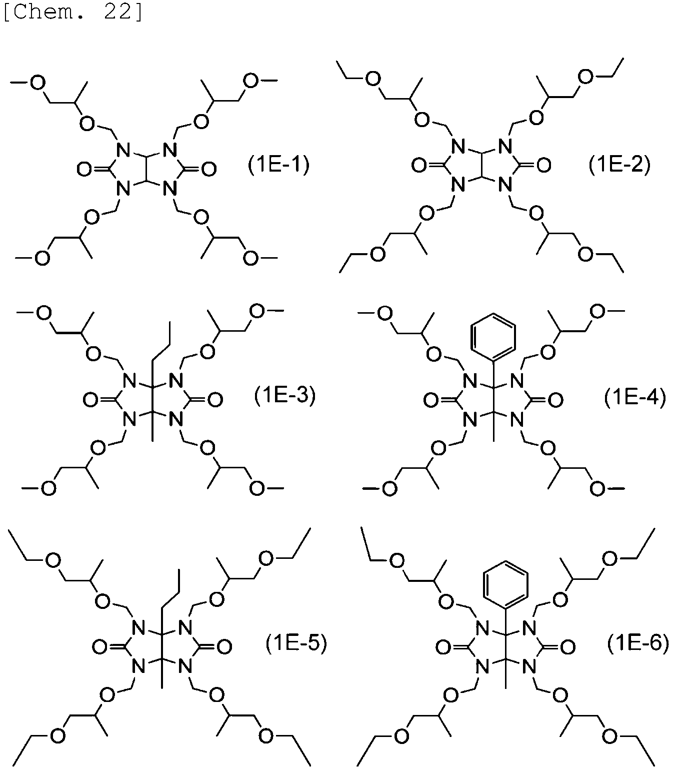

The glycoluril derivative represented by formula (1E) is obtained, for example, by a reaction of a glycoluril derivative represented by formula (2E) below with at least one compound represented by formula (3d) below.

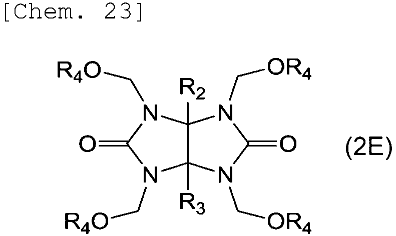

In formula (2E), R₂ and R₃ each independently represent a hydrogen atom, an alkyl group having 1 to 4 carbon atoms, or a phenyl group, and R₄'s each independently represent an alkyl group having 1 to 4 carbon atoms.

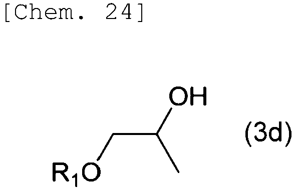

In formula (3d), R₁ represents a methyl group or an ethyl group.

Examples of the glycoluril derivative represented by formula (2E) include compounds represented by formulae (2E-1) to (2E-4) below. Further, examples of the compound represented by formula (3d) include compounds represented by formulae (3d-1) and (3d-2) below.

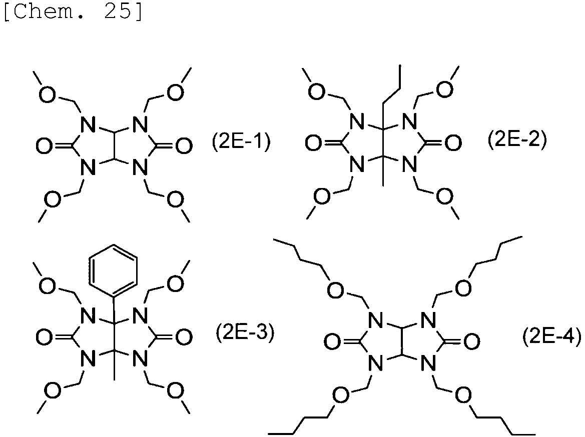

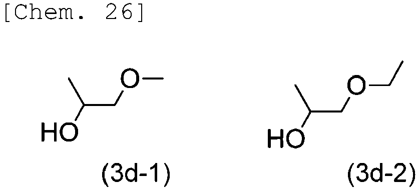

The urea compound is not particularly limited as long as it is a urea compound having a group that can react with the reactive group (for example, a hydroxy group) of the unit structure (B).

Examples of the urea compound include tetramethylolurea, tetramethoxymethylurea, a compound in which 1 to 4 methylol groups of tetramethylolurea are methoxymethylated or a mixture thereof, and tetramethoxyethylurea.

Examples of the compound having a phenolic hydroxy group include compounds represented by formula (111) or formula (112) below.

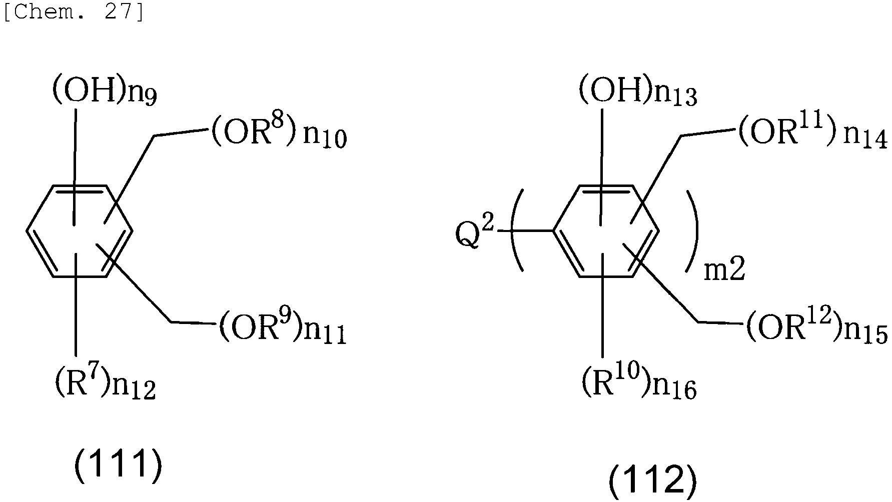

In formulae (111) and (112), Q² represents a single bond or an m2-valent organic group,
R⁸, R⁹, R¹¹, and R¹² each represent a hydrogen atom or a methyl group,
R⁷ and R¹⁰ each represent an alkyl group having 1 to 10 carbon atoms or an aryl group having 6 to 40 carbon atoms,
n₉ represents an integer that meets 1 ≤ n₉ ≤ 3, n₁₀ represents an integer that meets 2 ≤ n₁₀ ≤ 5, n₁₁ represents an integer that meets 0 ≤ n₁₁ ≤ 3, n₁₂ represents an integer that meets 0 ≤ n₁₂ ≤ 3, and an integer that meets 3 ≤ (n₉ + n₁₀ + n₁₁ + n₁₂) ≤ 6,
n₁₃ represents an integer that meets 1 ≤ n₁₃ ≤ 3, n₁₄ represents an integer that meets 1 ≤ n₁₄ ≤ 4, n₁₅ represents an integer that meets 0 ≤ n₁₅ ≤ 3, and n₁₆ represents an integer that meets 0 ≤ n₁₆ ≤ 3, and an integer that meets 2 ≤ (n₁₃ + n₁₄ + n₁₅ + n₁₆) ≤ 5, and
m2 represents an integer of 2 to 10.

Examples of the m2-valent organic group of Q² include an m2-valent organic group having 1 to 4 carbon atoms.

Examples of the compound represented by formula (111) or formula (112) include the following compounds.

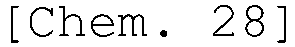

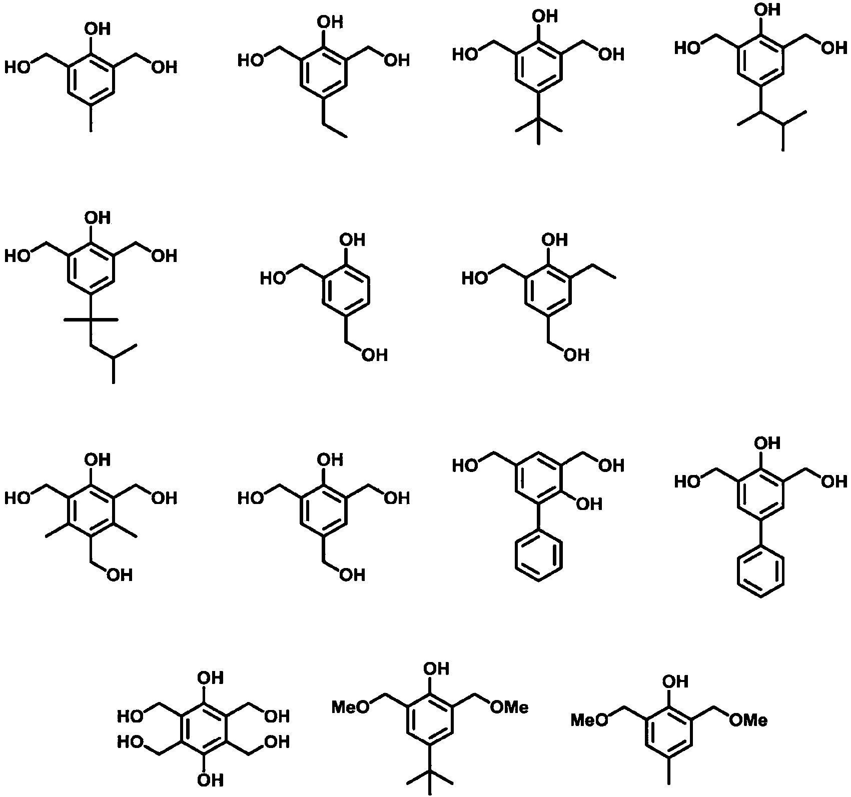

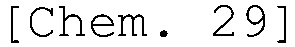

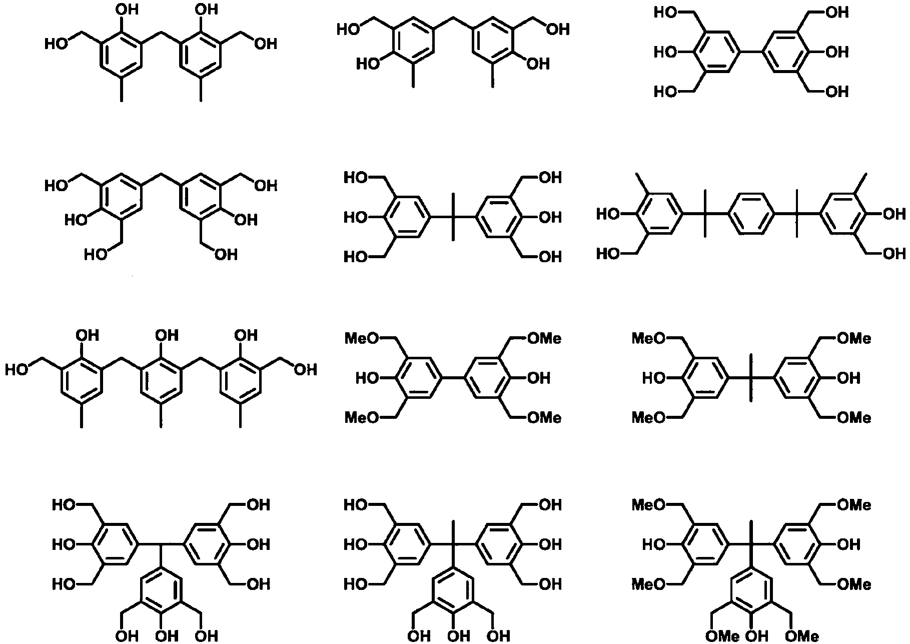

The compounds are available as products of Asahi Yukizai Corporation and Honshu Chemical Industry Co., Ltd. Examples of the product include TMOM-BP (trade name) manufactured by Asahi Yukizai Corporation.

Among the compounds, the glycoluril compound is preferable. Specifically, tetramethylolglycoluril, tetramethoxyglycoluril, tetramethoxymethylglycoluril, a compound in which 1 to 4 methylol groups of tetramethylolglycoluril are methoxymethylated or a mixture thereof, and a compound in which 1 to 4 methylol groups of tetramethylolglycoluril are acyloxymethylated or a mixture thereof are preferable, and tetramethoxymethylglycoluril is preferable.

The molecular weight of the crosslinking agent is not particularly limited, but is preferably 500 or less.

The content of the crosslinking agent in the resist underlayer film-forming composition is not particularly limited, and is preferably 5 mass% to 60 mass%, more preferably 10 mass% to 55 mass%, and particularly preferably 20 mass% to 50 mass% of the specific polymer.

### <Curing Catalyst>

As the curing catalyst contained as an optional component in the resist underlayer film-forming composition, both a thermal acid generator and a photoacid generator can be used, but it is preferable to use a thermal acid generator.

Examples of the thermal acid generator include sulfonic acid compounds and carboxylic acid compounds such as p-toluenesulfonic acid, trifluoromethanesulfonic acid, pyridinium-p-toluenesulfonate (pyridinium-p-toluenesulfonic acid), pyridinium phenolsulfonate, pyridinium p-hydroxybenzenesulfonate (p-phenolsulfonic acid pyridinium salt), pyridinium-trifluoromethanesulfonate, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, hydroxybenzoic acid, N-methylmorpholine-p-toluenesulfonate, N-methylmorpholine-p-hydroxybenzenesulfonate, and N-methylmorpholine-5-sulfosalicylate.

Examples of the photoacid generator include an onium salt compound, a sulfonimide compound, and a disulfonyl diazomethane compound.

Examples of the onium salt compound include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate; and sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate.

Examples of the sulfonimide compound include N-(trifluoromethanesulfonyloxy)succinimide, N-(nonafluoronormalbutanesulfonyloxy)succinimide, N-(camphorsulfonyloxy)succinimide, and N-(trifluoromethanesulfonyloxy)naphthalimide.

Examples of the disulfonyl diazomethane compound include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane.

Only one type of curing catalyst can be used, or two or more types thereof can be used in combination.

When a curing catalyst is used, the content ratio of the curing catalyst is, for example, 0.1 mass% to 50 mass%, and preferably 1 mass% to 30 mass% with respect to the crosslinking agent.

### <Other components>

To the resist underlayer film-forming composition, a surfactant can be further added in order to further improve the coatability against surface unevenness without generating a pinhole, a striation, and the like.

Examples of the surfactant include nonionic surfactants including polyoxyethylene alkyl ethers such as polyoxyethylene lauryl ether, polyoxyethylene stearyl ether, polyoxyethylene cetyl ether, and polyoxyethylene oleyl ether, polyoxyethylene alkyl allyl ethers such as polyoxyethylene octylphenol ether and polyoxyethylene nonylphenol ether, polyoxyethylene-polyoxypropylene block copolymers, sorbitan fatty acid esters such as sorbitan monolaurate, sorbitan monopalmitate, sorbitan monostearate, sorbitan monooleate, sorbitan trioleate, and sorbitan tristearate, and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate, fluorine-based surfactants such as EFTOP EF301, EF303, and EF352 (trade name, manufactured by Tochem Products Co., Ltd.), MEGAFAC F171, F173, and R-30 (trade name, manufactured by DIC Corporation), Fluorad FC430 and FC431 (trade name, manufactured by Sumitomo 3M Limited), Asahi Guard AG710, Surflon S-382, SC101, SC102, SC103, SC104, SC105, and SC106 (trade name, manufactured by AGC Corporation), and an organosiloxane polymer KP341 (manufactured by Shin-Etsu Chemical Co., Ltd.).

The blending amount of these surfactants is not particularly limited, but is usually 2.0 mass% or less, and preferably 1.0 mass% or less with respect to the resist underlayer film-forming composition.

These surfactants may be added alone, or two or more types thereof can also be added in combination.

### <Solvent>

The resist underlayer film-forming composition may contain a solvent.

As the solvent, an organic solvent generally used in a chemical liquid for a semiconductor lithography process is preferable. Specific examples of the solvent include ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monomethyl ether, propylene glycol monoethyl ether, propylene glycol monomethyl ether acetate, propylene glycol propyl ether acetate, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxy cyclopentane, anisole, γ-butyrolactone, N-methylpyrrolidone, N,N-dimethylformamide, and N,N-dimethylacetamide. One of these solvents can be used alone, or two or more of these solvents can be used in combination.

Among these solvents, propylene glycol monomethyl ether, propylene glycol monomethyl ether acetate, ethyl lactate, butyl lactate, and cyclohexanone are preferable. In particular, propylene glycol monomethyl ether and propylene glycol monomethyl ether acetate are preferable.

The content of the solvent in the resist underlayer film-forming composition is not particularly limited, and is preferably 80 mass% to 99.99 mass%, more preferably 90 mass% to 99.95 mass%, and particularly preferably 95 mass% to 99.9 mass%.

### <Nitrogen Atom-Containing Substrate>

The substrate on which the underlayer film of the resist film is formed by the resist underlayer film-forming composition of the present invention described above is a nitrogen atom-containing substrate.

Examples of the nitrogen atom-containing substrate include a substrate formed of a compound having a bond between a metal atom or a metalloid atom and a nitrogen atom, and a substrate having a nitrogen atom-containing film formed of a compound having a bond between a metal atom or a metalloid atom and a nitrogen atom. Nitrogen atoms may be contained in both the substrate and the film of the substrate.

The metal atom is not particularly limited, and examples thereof include titanium, gallium, tungsten, hafnium, zirconium, aluminum, and copper. The metalloid atom is not particularly limited, and examples thereof include boron, silicon, germanium, arsenic, antimony, and tellurium.

Examples of the substrate include a silicon wafer, a germanium wafer, and a compound semiconductor wafer of gallium arsenide, indium phosphide, gallium nitride, indium nitride, aluminum nitride, or the like. Among them, examples of the substrate formed of a compound having a bond with a nitrogen atom include gallium nitride, indium nitride, and aluminum nitride.

In addition, in a case where a film is formed on the substrate, examples of the film include a polysilicon film, a silicon oxide film, a silicon nitride film, a boro-phospho silicate glass (BPSG) film, a titanium nitride film, a titanium nitride oxide film, a tungsten film, a gallium nitride film, and a gallium arsenide film formed by an atomic layer deposition (ALD) method, a chemical vapor deposition (CVD) method, a reactive sputtering method, an ion plating method, a vacuum vapor deposition method, or a spin coating method (spin-on-glass: SOG). Among them, examples of the nitrogen atom-containing film formed of a compound having a bond with a nitrogen atom include a silicon nitride film, a titanium nitride film, a titanium nitride oxide film, and a gallium nitride film.

The upper limit of the film thickness of the nitrogen atom-containing film is, for example, 200 nm, 150 nm, or 100 nm. The lower limit is 5 nm or 10 nm.

Conventionally, when a resist film is formed on the above-described nitrogen atom-containing substrate and a resist pattern is obtained by irradiation with light or an electron beam, the accuracy of the pattern may be deteriorated. This is considered to be because the amine components derived from the nitrogen atom-containing substrate are diffused from the substrate side to the resist side in some process. In contrast, when an underlayer film is formed by the resist underlayer film-forming composition of the present invention, it is possible to suppress a decrease in accuracy of the photoresist pattern described above.

### (Underlayer Film)

The underlayer film (also referred to as a resist underlayer film) of the present invention is a cured product of the above-described resist underlayer film-forming composition.

The resist underlayer film can be produced, for example, by applying the above-described resist underlayer film-forming composition onto a nitrogen atom-containing substrate and baking the composition.

Specifically, the resist underlayer film-forming composition of the present invention is applied onto the nitrogen atom-containing substrate with an appropriate application method using a spinner, a coater, or the like. Thereafter, an underlayer film is formed by performing baking using a heating unit such as a hot plate. The baking conditions are appropriately selected from a baking temperature of 100°C to 400°C and a baking time of 0.3 minutes to 60 minutes. Preferably, the baking temperature is 120°C to 350°C and the baking time is 0.5 minutes to 30 minutes. More preferably, the baking temperature is 150°C to 300°C and the baking time is 0.8 minutes to 10 minutes.

The film thickness of the underlayer film is, for example, 0.001 µm (1 nm) to 10 µm, 0.002 µm (2 nm) to 1 µm, 0.005 µm (5 nm) to 0.5 µm (500 nm), 0.001 µm (1 nm) to 0.05 µm (50 nm), 0.002 µm (2 nm) to 0.05 µm (50 nm), 0.003 µm (3 nm) to 0.05 µm (50 nm), 0.004 µm (4 nm) to 0.05 µm (50 nm), 0.005 µm (5 nm) to 0.05 µm (50 nm), 0.003 µm (3 nm) to 0.03 µm (30 nm), 0.003 µm (3 nm) to 0.02 µm (20 nm), 0.005 µm (5 nm) to 0.02 µm (20 nm), 0.005 µm (5 nm) to 0.02 µm (20 nm), 0.003 µm (3 nm) to 0.01 µm (10 nm), 0.005 µm (5 nm) to 0.01 µm (10 nm), 0.003 µm (3 nm) to 0.006 µm (6 nm), 0.003 µm (3 nm) to 0.01 µm (10 nm), or 0.005 µm (5 nm).

The method for measuring the film thickness of the underlayer film in the present description is as follows.
· Measurement device name: Ellipsometric film thickness measurement device RE-3100 (SCREEN Holdings Co., Ltd.)
· Single wavelength ellipsometer (SWE) mode
· Arithmetic average of measurements at 8 points (for example, measurement is made at 8 points at intervals of 1 cm in X direction of wafer)

### (Method for Producing Semiconductor Element)

The semiconductor element producing method of the present invention includes at least the following steps.
· forming an underlayer film on the nitrogen atom-containing substrate using the resist underlayer film-forming composition of the present invention;
· forming a resist film of either a photoresist film or an electron beam resist film on the underlayer film;
· irradiating the resist film with light or an electron beam, and then developing the resist film to obtain a resist pattern; and
· forming a patterned underlayer film by etching the underlayer film using the resist pattern as a mask.

The resist film is usually formed on the underlayer film.

The film thickness of the resist film is, for example, 3,000 nm or less, 2,000 nm or less, 1,800 nm or less, 1,500 nm or less, or 1,000 nm or less. The lower limit is 100 nm, 80 nm, 50 nm, 30 nm, 20 nm, or 10 nm.

The resist film formed on the underlayer film by a known method (for example, application and baking of a resist composition) is not particularly limited as long as it responds to light or an electron beam (EB) used for irradiation. Any of a negative photoresist and a positive photoresist can be used.

In the present description, a resist that responds to an EB is also referred to as a photoresist.

Examples of the photoresist include a positive photoresist made of a novolac resin and 1,2-naphthoquinonediazide sulfonic acid ester, a chemically amplified photoresist made of a binder having a group, which is decomposed by an acid to increase the alkali dissolution rate, and a photoacid generator, a chemically amplified photoresist made of a low molecular compound, which is decomposed by an acid to increase the alkali dissolution rate of the photoresist, an alkali-soluble binder, and a photoacid generator, a chemically amplified photoresist made of a binder having a group, which is decomposed by an acid to increase the alkali dissolution rate, a low molecular compound, which is decomposed by an acid to increase the alkali dissolution rate of the photoresist, and a photoacid generator, and a resist containing a metal element. Examples thereof include V146G (trade name) manufactured by JSR Corporation, APEX-E (trade name) manufactured by Shipley, PAR710 (trade name) manufactured by SUMITOMO CHEMICAL COMPANY, LIMITED, and AR2772 and SEPR430 (trade names) manufactured by Shin-Etsu Chemical Co., Ltd. Further, examples thereof include a fluorine-containing polymer-based photoresist as described in Proc. SPIE, Vol. 3999, 330-334 (2000), Proc. SPIE, Vol. 3999, 357-364 (2000), or Proc. SPIE, Vol. 3999, 365-374 (2000).

In addition, so-called resist compositions such as resist compositions described in WO2019/188595, WO2019/187881, WO2019/187803, WO2019/167737, WO2019/167725, WO2019/187445, WO2019/167419, WO2019/123842, WO2019/054282, WO2019/058945, WO2019/058890, WO2019/039290, WO2019/044259, WO2019/044231, WO2019/026549, WO2018/193954, WO2019/172054, WO2019/021975, WO2018/230334, WO2018/194123, JP 2018-180525 A, WO2018/190088, JP 2018-070596, JP 2018-028090 A, JP 2016-153409 A, JP 2016-130240 A, JP 2016-108325 A, JP 2016-047920 A, JP 2016-035570 A, JP 2016-035567 A, JP 2016-035565 A, JP 2019-101417 A, JP 2019-117373 A, JP 2019-052294 A, JP 2019-008280 A, JP 2019-008279 A, JP 2019-003176 A, JP 2019-003175 A, JP 2018-197853 A, JP 2019-191298 A, JP 2019-061217 A, JP 2018-045152 A, JP 2018-022039 A, JP 2016-090441 A, JP 2015-10878 A, JP 2012-168279 A, JP 2012-022261 A, JP 2012-022258 A, JP 2011-043749 A, JP 2010-181857 A, JP 2010-128369 A, WO2018/031896, JP 2019-113855 A, WO2017/156388, WO2017/066319, JP 2018-41099 A, WO2016/065120, WO2015/026482, JP 2016-29498 A, and JP 2011-253185 A, radiation-sensitive resin compositions, high-resolution patterning compositions based on organometallic solutions, and metal-containing resist compositions can be used, but are not limited to these.

Examples of the resist composition include the following compositions.

An actinic ray-sensitive or radiation-sensitive resin composition containing a resin A having a repeating unit having an acid-decomposable group in which a polar group is protected by a protecting group to be removed by an action of an acid, and a compound represented by general formula (121) below.

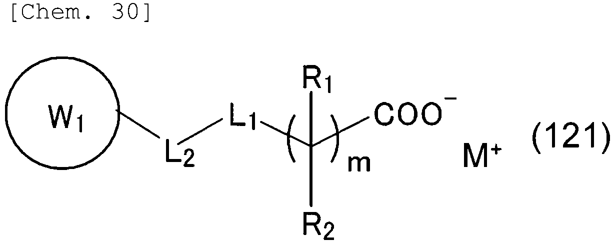

In general formula (121), m represents an integer of 1 to 6.
R₁ and R₂ each independently represent a fluorine atom or a perfluoroalkyl group.
L₁ represents -O-, -S-, -COO-, -SO₂-, or -SO₃-.
L₂ represents an alkylene group which may have a substituent, or a single bond.
W₁ represents a cyclic organic group which may have a substituent.
M⁺ represents a cation.

A metal-containing film forming composition for extreme ultraviolet ray or electron beam lithography, containing: a compound having a metal-oxygen covalent bond; and a solvent, in which metal elements constituting the above compound belong to the third to seventh periods of Groups 3 to 15 of the periodic table.

A radiation-sensitive resin composition containing: a polymer having a first structural unit represented by the following formula (31) and a second structural unit represented by the following formula (32) and containing an acid-dissociable group; and an acid generator.

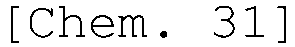

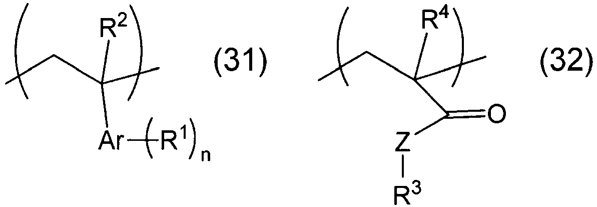

In formula (31), Ar is a group obtained by removing (n + 1) hydrogen atoms from an arene having 6 to 20 carbon atoms, R¹ is a hydroxy group, a sulfanyl group, or a monovalent organic group having 1 to 20 carbon atoms, n is an integer of 0 to 11, when n is 2 or more, a plurality of R¹'s are identical or different, and R² is a hydrogen atom, a fluorine atom, a methyl group, or a trifluoromethyl group. In formula (32), R³ is a monovalent group having 1 to 20 carbon atoms and containing the acid-dissociable group, Z is a single bond, an oxygen atom, or a sulfur atom, and R⁴ is a hydrogen atom, a fluorine atom, a methyl group, or a trifluoromethyl group.

A resist composition containing: a resin (A1) containing a structural unit having a cyclic carbonate structure, a structural unit represented by the following formula, and a structural unit having an acid-unstable group; and an acid generator.

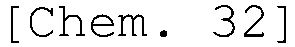

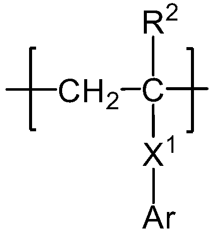

In the formula,
R² represents an alkyl group which has 1 to 6 carbon atoms and may have a halogen atom or represents a hydrogen atom or a halogen atom, X¹ represents a single bond, -CO-O-*, or -CO-NR⁴-*, * represents a bond with -Ar, R⁴ represents a hydrogen atom or an alkyl group having 1 to 4 carbon atoms, and Ar represents an aromatic hydrocarbon group which has 6 to 20 carbon atoms and may have one or more groups selected from the group consisting of a hydroxy group and a carboxyl group.

Examples of the resist film include the following.

A resist film containing a base resin containing a repeating unit represented by the following formula (a1) and/or a repeating unit represented by the following formula (a2), and a repeating unit that generates an acid bonded to a polymer main chain by exposure.

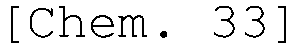

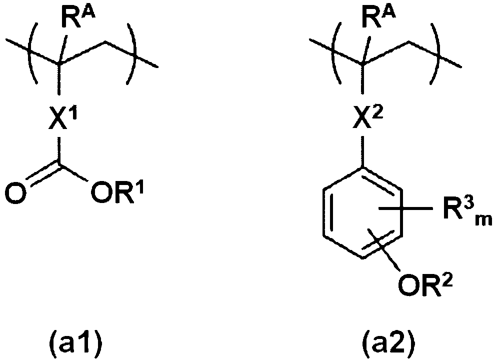

In formulae (a1) and (a2), R^{A}'s each independently are a hydrogen atom or a methyl group, R¹ and R² are each independently a tertiary alkyl group having 4 to 6 carbon atoms, R³'s are each independently a fluorine atom or a methyl group, m is an integer of 0 to 4, X¹ is a single bond, a phenylene group, a naphthylene group, or a linking group having 1 to 12 carbon atoms and including at least one type selected from an ester bond, a lactone ring, a phenylene group, and a naphthylene group, and X² is a single bond, an ester bond, or an amide bond.

Examples of the resist material include the following.

A resist material containing a polymer having a repeating unit represented by the following formula (b1) or formula (b2).

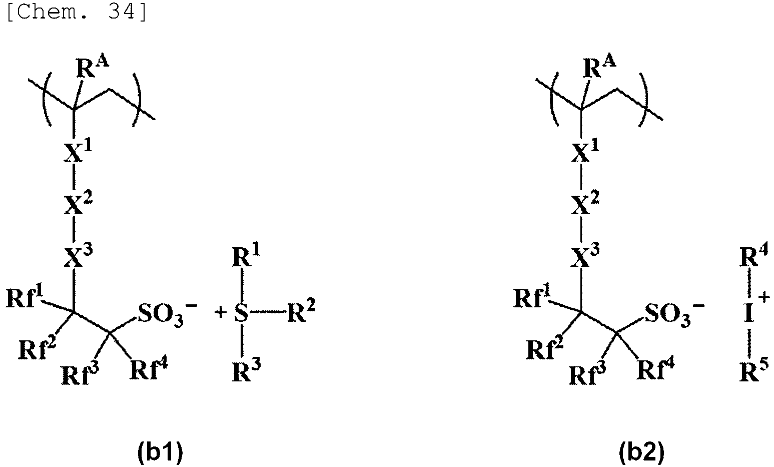

In formulae (b1) and (b2), R^{A} is a hydrogen atom or a methyl group, X¹ is a single bond or an ester group, X² is a linear, branched, or cyclic alkylene group having 1 to 12 carbon atoms or an arylene group having 6 to 10 carbon atoms, and some of methylene groups included in the alkylene group may be substituted with an ether group, an ester group, or a lactone ring-containing group, and at least one hydrogen atom included in X² is substituted with a bromine atom, X³ is a single bond, an ether group, an ester group, or a linear, branched, or cyclic alkylene group having 1 to 12 carbon atoms, and some of methylene groups included in the alkylene group may be substituted with an ether group or an ester group, Rf¹ to Rf⁴ are each independently a hydrogen atom, a fluorine atom, or a trifluoromethyl group, and at least one of Rf¹ to Rf⁴ is a fluorine atom or a trifluoromethyl group, Rf¹ and Rf² may be combined to form a carbonyl group, R¹ to R⁵ are each independently a linear, branched, or cyclic alkyl group having 1 to 12 carbon atoms, a linear, branched, or cyclic alkenyl group having 2 to 12 carbon atoms, an alkynyl group having 2 to 12 carbon atoms, an aryl group having 6 to 20 carbon atoms, an aralkyl group having 7 to 12 carbon atoms, or an aryloxyalkyl group having 7 to 12 carbon atoms, and some or all of hydrogen atoms of these groups may be substituted with a hydroxy group, a carboxyl group, a halogen atom, an oxo group, a cyano group, an amide group, a nitro group, a sultone group, a sulfone group, or a sulfonium salt-containing group, and some of methylene groups included in these groups may be substituted with an ether group, an ester group, a carbonyl group, a carbonate group, or a sulfonic acid ester group, and R¹ and R² may be bonded to each other to form a ring together with the sulfur atom to which R¹ and R² are bonded.

A resist material containing a base resin containing a polymer containing a repeating unit represented by the following formula (a).

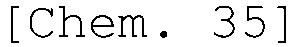

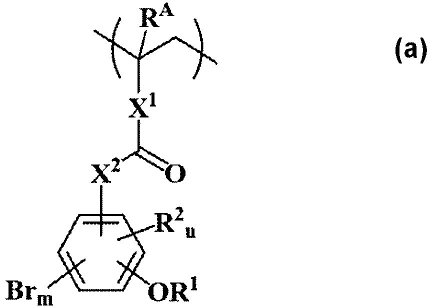

In formula (a), R² is a hydrogen atom or a methyl group, R¹ is a hydrogen atom or an acid-unstable group, R² is a linear, branched, or cyclic alkyl group having 1 to 6 carbon atoms or a halogen atom other than bromine, X¹ is a single bond, a phenylene group, or a linear, branched, or cyclic alkylene group which has 1 to 12 carbon atoms and may include an ester group or a lactone ring, X² is -O-, - O-CH₂-, or -NH-, m is an integer of 1 to 4, and u is an integer of 0 to 3, provided that m + u is an integer of 1 to 4.

A resist composition which generates an acid by exposure and of which solubility in a developer is changed by an action of the acid, the resist composition containing:
a base material component (A) of which solubility in a developer is changed by an action of an acid and a fluorine additive component (F) which exhibits decomposability in an alkaline developer, in which
the fluorine additive component (F) contains a fluororesin component (F1) having a constituent unit (f1) containing a base dissociable group and a constituent unit (f2) containing a group represented by the following general formula (f2-r-1).

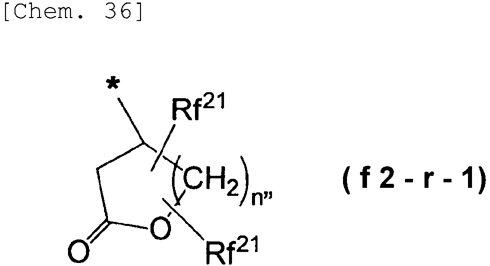

In formula (f2-r-1), Rf²¹'s each independently are a hydrogen atom, an alkyl group, an alkoxy group, a hydroxy group, a hydroxyalkyl group, or a cyano group, n" is an integer of 0 to 2, and * is a bond.

The constituent unit (f1) includes a constituent unit represented by the following general formula (f1-1) or a constituent unit represented by the following general formula (f1-2).

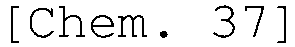

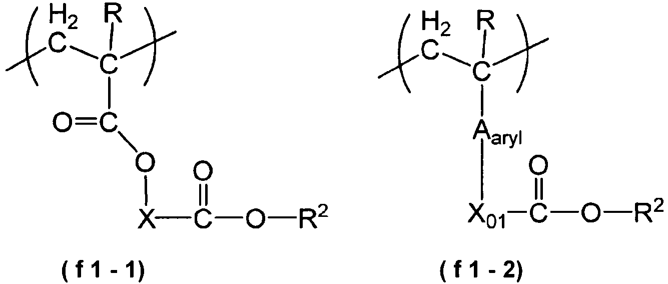

In formulae (f1-1) and (f1-2), R's each independently are a hydrogen atom, an alkyl group having 1 to 5 carbon atoms, or a halogenated alkyl group having 1 to 5 carbon atoms, X is a divalent linking group not having an acid-dissociable site, A_{aryl} is a divalent aromatic ring group which may have a substituent, X₀₁ is a single bond or a divalent linking group, and R² are each independently an organic group having a fluorine atom.

Examples of the coating, the coating solution, and the coating composition include the following.

A coating containing a metal oxo-hydroxo network having organic ligands via metal carbon bonds and/or metal carboxylate bonds.

An inorganic oxo-hydroxo-based composition.

A coating solution containing: an organic solvent; a first organometallic composition represented by the formula R_{z}SnO_{(2-(z/2)-(x/2))}(OH)ₓ (here, 0 < z ≤ 2 and 0 < (z + x) ≤ 4), the formula R'ₙSnX₄₋ₙ (here, n = 1 or 2), or a mixture thereof, in which R and R' independently represent a hydrocarbyl group having 1 to 31 carbon atoms and X represents a ligand having a hydrolysable bond to Sn or a combination of such ligands; and a hydrolysable metal compound represented by the formula MX'ᵥ (here, M represents a metal selected from groups 2 to 16 in the periodic table, v is a number of v = 2 to 6, and X' represents a ligand having a hydrolysable M-X bond or a combination of such ligands).

A coating solution containing an organic solvent and a first organometallic compound represented by the formula RSnO_{(3/2-x/2)}(OH)ₓ (where 0 < x < 3), in which the solution contains from about 0.0025 M to about 1.5 M of tin, R is an alkyl group or a cycloalkyl group having 3 to 31 carbon atoms, and the alkyl group or cycloalkyl group is bonded to tin at a secondary or tertiary carbon atom.

An inorganic pattern forming precursor aqueous solution containing a mixture of water, a metal suboxide cation, a polyatomic inorganic anion, and a radiation-sensitive ligand containing a peroxide group.

Irradiation with light or an electron beam is performed, for example, through a mask (reticle) for formation of a predetermined pattern. For example, an i-line, a KrF excimer laser, an ArF excimer laser, an extreme ultraviolet ray (EUV), or an electron beam (EB) is used. The resist underlayer film-forming composition of the present invention is preferably applied for electron beam (EB) or extreme ultraviolet (EUV: 13.5 nm) irradiation, and more preferably applied for extreme ultraviolet (EUV) exposure.

The irradiation energy of the electron beam and the exposure amount of light are not particularly limited.

Post exposure bake (PEB) may be performed after irradiation with the light or electron beam and before development.

The baking temperature is not particularly limited, and is preferably 60°C to 150°C, more preferably 70°C to 120°C, and particularly preferably 75°C to 110°C.

The baking time is not particularly limited, but is preferably 1 second to 10 minutes, more preferably 10 seconds to 5 minutes, and particularly preferably 30 seconds to 3 minutes.

For the development, for example, an alkaline developer is used.

The developing temperature is, for example, 5°C to 50°C.

The developing time is, for example, 10 seconds to 300 seconds.

As the alkaline developer, for example, an aqueous solution of an alkali such as an inorganic alkali (for example, sodium hydroxide, potassium hydroxide, sodium carbonate, sodium silicate, sodium metasilicate, or ammonia water), a primary amine (for example, ethylamine or n-propylamine), a secondary amine (for example, diethylamine or di-n-butylamine), a tertiary amine (for example, triethylamine or methyldiethylamine), an alcoholamine (for example, dimethylethanolamine or triethanolamine), a quaternary ammonium salt (for example, tetramethylammonium hydroxide, tetraethylammonium hydroxide, or choline), or a cyclic amine (for example, pyrrole or piperidine) can be used. Further, an alcohol such as isopropyl alcohol, or a surfactant such as a nonionic surfactant can be added in an appropriate amount to the aqueous solution of an alkali and used. Among these developers, an aqueous solution of a quaternary ammonium salt is preferred, and an aqueous solution of tetramethylammonium hydroxide and an aqueous solution of choline are more preferred. Further, a surfactant or the like can also be added to these developers. A method of performing development with an organic solvent such as butyl acetate instead of the alkaline developer, and developing a part where the alkali dissolution rate of the photoresist is not improved can also be used.

Subsequently, the underlayer film is etched using the formed resist pattern as a mask. The etching may be dry etching or wet etching, but is preferably dry etching.

When the film is formed on the surface of a nitrogen-containing substrate used, the surface of the film is exposed, and when the film is not formed on the surface of a nitrogen-containing substrate used, the surface of the substrate is exposed. Then, a semiconductor element can be produced through a step of processing the substrate with a known method (dry etching method or the like).

### Examples

Next, the contents of the present invention will be specifically described with reference to Examples, but the present invention is not limited thereto.

The weight average molecular weights of the polymers shown in the following Synthesis Examples 1 to 6 and Comparative Synthesis Example 1 in the present description are the measurement results by gel permeation chromatography (hereinafter, abbreviated as GPC). In the measurement, a GPC apparatus manufactured by Tosoh Corporation was used, and measurement conditions and the like are as follows:
GPC column: TSKgel Super-Multipore HZ-N (two columns)
Column temperature: 40°C
Solvent: tetrahydrofuran (THF)
Flow rate: 0.35 ml/min
Standard sample: Polystyrene (manufactured by Tosoh Corporation)

### <Synthesis Example 1>

In 32.00 g of propylene glycol monomethyl ether acetate, 5.68 g (molar ratio relative to the whole polymer 1: 75%) of 2-vinylnaphthalene, 1.60 g (molar ratio relative to the whole polymer 1: 25%) of 2-hydroxyethyl methacrylate, and 0.73 g of 2,2'-azobisisobutyronitrile were dissolved. A reaction vessel was purged with nitrogen, and then the solution was heated and stirred at 140°C for about 4 hours. This reaction solution was added dropwise to isopropyl alcohol, and a precipitate was recovered by suction filtration, and then dried at 60°C under reduced pressure to recover a polymer 1. The weight average molecular weight Mw measured by GPC in terms of polystyrene was 8,500. The structure present in the polymer 1 is represented by the following formula.

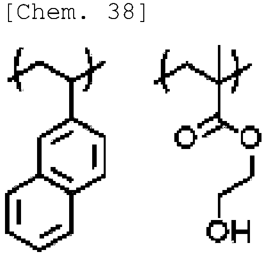

### <Synthesis Example 2>

In 40.00 g of propylene glycol monomethyl ether acetate, 4.75 g (molar ratio relative to the whole polymer 2: 55%) of 2-vinylnaphthalene, 2.96 g (molar ratio relative to the whole polymer 2: 30%) of benzyl methacrylate, 1.21 g (molar ratio relative to the whole polymer 2: 15%) of 2-hydroxypropyl methacrylate, and 1.07 g of 2,2'-azobisisobutyronitrile were dissolved. A reaction vessel was purged with nitrogen, and then the solution was heated and stirred at 140°C for about 4 hours. This reaction solution was added dropwise to isopropyl alcohol, and a precipitate was recovered by suction filtration, and then dried at 60°C under reduced pressure to recover a polymer 2. The weight average molecular weight Mw measured by GPC in terms of polystyrene was 5,900. The structure present in the polymer 2 is represented by the following formula.

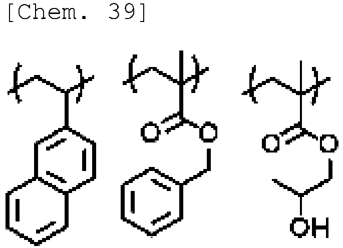

### <Synthesis Example 3>

In 40.00 g of propylene glycol monomethyl ether acetate, 5.00 g (molar ratio relative to the whole polymer 3: 55%) of 2-vinylnaphthalene, 2.91 g (molar ratio relative to the whole polymer 3: 26%) of 2-phenylethyl methacrylate, 1.61 g (molar ratio relative to the whole polymer 3: 19%) of 2-hydroxypropyl methacrylate, and 0.48 g of 2,2'-azobisisobutyronitrile were dissolved. A reaction vessel was purged with nitrogen, and then the solution was heated and stirred at 140°C for about 4 hours. The reaction solution was added dropwise to methanol, and the precipitate was recovered by suction filtration and then dried at 60°C under reduced pressure to recover a polymer 3. The weight average molecular weight Mw measured by GPC in terms of polystyrene was 6,600. The structure present in the polymer 3 is represented by the following formula.

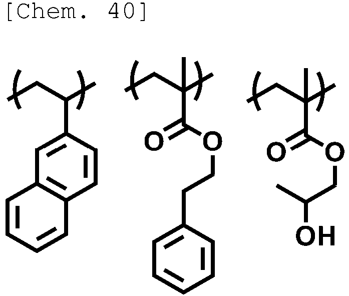

### <Synthesis Example 4>

In 24.00 g of propylene glycol monomethyl ether acetate, 2.94 g (molar ratio relative to the whole polymer 4: 50%) of 2-vinylnaphthalene, 1.24 g (molar ratio relative to the whole polymer 4: 25%) of hydroxyethyl methacrylate, 1.71 g (molar ratio relative to the whole polymer 4: 25%) of N-cyclohexylmaleimide, and 0.12 g of 2,2'-azobisisobutyronitrile were dissolved. A reaction vessel was purged with nitrogen, and then the solution was heated and stirred at 140°C for about 4 hours. This reaction solution was added dropwise to isopropyl alcohol, and a precipitate was recovered by suction filtration, and then dried at 60°C under reduced pressure to recover a polymer 4. The weight average molecular weight Mw measured by GPC in terms of polystyrene was 16,300. The structure present in the polymer 4 is represented by the following formula.

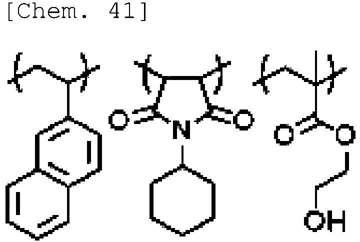

### <Synthesis Example 5>

In 24.00 g of propylene glycol monomethyl ether acetate, 2.86 g (molar ratio relative to the whole polymer 5: 50%) of 2-vinylnaphthalene, 1.68 g (molar ratio relative to the whole polymer 5: 25%) of N-cyclohexylmaleimide, 1.32 g (molar ratio relative to the whole polymer 5: 25%) of N-hydroxyethylmaleimide, and 0.12 g of 2,2'-azobisisobutyronitrile were dissolved. A reaction vessel was purged with nitrogen, and then the solution was heated and stirred at 140°C for about 4 hours. This reaction solution was added dropwise to isopropyl alcohol, and the precipitate was recovered by suction filtration, and then dried at 60°C under reduced pressure to recover a polymer 5. The weight average molecular weight Mw measured by GPC in terms of polystyrene was 11,900. The structure present in the polymer 5 is represented by the following formula.

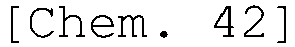

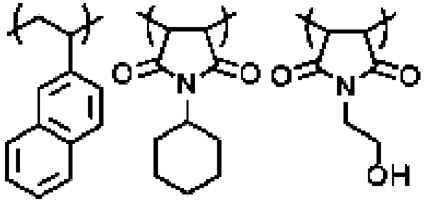

### <Synthesis Example 6>

In 40.00 g of propylene glycol monomethyl ether acetate, 7.22 g (molar ratio relative to the whole polymer 6: 71%) of 2-vinylnaphthalene, 0.50 g (molar ratio relative to the whole polymer 6: 10%) of 4-tert-butylstyrene, 1.80 g (molar ratio relative to the whole polymer 6: 19%) of 2-hydroxypropyl methacrylate, and 0.48 g of 2,2'-azobisisobutyronitrile were dissolved. A reaction vessel was purged with nitrogen, and then the solution was heated and stirred at 140°C for about 4 hours. The reaction solution was added dropwise to methanol, and a precipitate was recovered by suction filtration and then dried at 60°C under reduced pressure to recover a polymer 6. The weight average molecular weight Mw measured by GPC in terms of polystyrene was 7,300. The structure present in the polymer 6 is represented by the following formula.

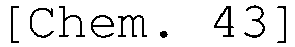

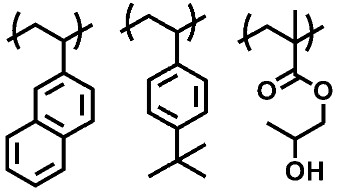

### <Comparative Synthesis Example 1>

To 682.00 g of propylene glycol monomethyl ether in a reaction vessel, 100.00 g of monoallyl diglycidyl isocyanurate (manufactured by Shikoku Chemicals Corporation), 66.4 g of 5,5-diethylbarbituric acid (manufactured by Tateyama Kasei Co., Ltd), and 4.1 g of benzyltriethylammonium chloride were added and dissolved. The reaction vessel was purged with nitrogen, and then a reaction was allowed to proceed at 130°C for 24 hours to obtain a solution containing a comparative polymer 1. As a result of GPC analysis, the obtained comparative polymer 1 had a weight average molecular weight of 6,800 in terms of standard polystyrene. The structure present in the comparative polymer 1 is represented by the following formula.

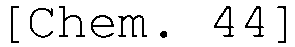

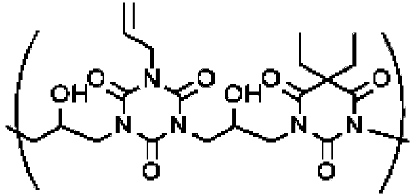

### (Preparation 1 of Underlayer Film-Forming Composition)

The components were mixed in the proportions shown in Table 1, and the mixture was filtered using a polyethylene microfilter having a pore size of 0.05 µm to prepare underlayer film-forming compositions of Examples 1 to 6 and an underlayer film-forming composition of Comparative Example 1, respectively.

Abbreviations in Table 1 are as follows.
PyPTS: pyridinium p-toluenesulfonic acid
PGME: Propylene glycol monomethyl ether
PGMEA: Propylene glycol monomethyl ether acetate

### PL-LI: 1,3,4,6-tetrakis(methoxymethyl)glycoluril (the following structural formula)

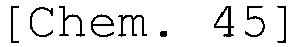

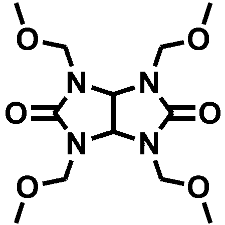

**[Table 1]**

| | Component 1 | Component 2 | Curing catalyst | Solvent | |
|---|---|---|---|---|---|
| Example 1 | Polymer 1 | PL-LI | PyPTS | PGME | PGMEA |
| (parts by mass) | 0.173 | 0.043 | 0.004 | 30 | 70 |
| Example 2 | Polymer 2 | PL-LI | PyPTS | PGME | PGMEA |
| (parts by mass) | 0.173 | 0.043 | 0.004 | 30 | 70 |
| Example 3 | Polymer 3 | PL-LI | PyPTS | PGME | PGMEA |
| (parts by mass) | 0.173 | 0.043 | 0.004 | 30 | 70 |
| Example 4 | Polymer 4 | PL-LI | PyPTS | PGME | PGMEA |
| (parts by mass) | 0.173 | 0.043 | 0.004 | 30 | 70 |
| Example 5 | Polymer 5 | PL-LI | PyPTS | PGME | PGMEA |
| (parts by mass) | 0.173 | 0.043 | 0.004 | 30 | 70 |
| Example 6 | Polymer 6 | PL-LI | PyPTS | PGME | PGMEA |
| (parts by mass) | 0.173 | 0.043 | 0.004 | 30 | 70 |
| Comparative Example 1 | Comparative Polymer 1 | PL-LI | PyPTS | PGME | PGMEA |
| (parts by mass) | 0.157 | 0.039 | 0.004 | 70 | 30 |

### (Evaluation of Resist Patterning)

### <Formation of Underlayer Film>

Each of the underlayer film-forming compositions of Examples 1 to 6 and Comparative Example 1 was applied onto a nitrogen-containing substrate having a SiON film of 31.5 nm using a spinner. The wafer was baked on a hot plate at 205 to 250°C for 60 seconds to obtain underlayer films of Examples 1 to 6 and Comparative Example 1, each having a film thickness of 5 nm.

An underlayer film-coated wafer was prepared by the same method as described above, and an underlayer film stored in a clean room for 48 hours was prepared.

### <Test of Resist Pattern Formation by ArF Scanner>

A commercially available resist solution for ArF (manufactured by Shin-Etsu Chemical Co., Ltd., trade name: SAIL X-206) was applied onto the underlayer films of Example 1 to 6 and Comparative Example 1 stored in a clean room for the predetermined time, and baked at 85°C for 60 seconds to form a photoresist film having a film thickness of 100 nm. A scanner NSR-S307E, manufactured by Nikon Corporation (wavelength 193 nm, NA = 0.85, σ = 0.93/0.85) was used to expose each of the films through a mask designed such that the line width and the width between the lines of the photoresist after the development were 0.1 µm, i.e. a 0.1 µm dense line with a line and space (L/S) = 1/1 was formed. Thereafter, the film was baked on a hot plate at 95°C for 60 seconds, cooled, and then developed using butyl acetate for 60 seconds to form a negative pattern on the resist underlayer film.

For the obtained photoresist pattern, a photoresist film was immediately formed without storing the underlayer film-coated wafer in a clean room, and then observation was performed from above the exposed and developed resist pattern to form a 100 nm line/200 nm pitch (line and space (L/S = 1/1)). Separately, a photoresist film was formed on the underlayer film obtained by storing the underlayer film-coated wafer in a clean room for 48 hours by the same method, and then the line size of the exposed and developed resist pattern was confirmed. The exposure was performed at the optimum irradiation energy in each of Examples. The length measurement of the pattern was confirmed with a scanning electron microscope (CG4100, manufactured by Hitachi High-Technologies Corporation), and the results of confirming the change amounts of the pattern size (after 48 hours) when the film was stored in a clean room for 48 hours and the pattern size (after 0 hours) when the film was continuously exposed to light are shown in Table 2.

**[Table 2]**

| | Pattern size | | Pattern Size Change Amount |
|---|---|---|---|
| | After 0 hours | After 48 hours | |
| Example 1 | 105.5 nm | 105.0 nm | 0.5 nm |
| Example 2 | 105.0 nm | 104.3 nm | 0.7 nm |
| Example 3 | 107.3 nm | 106.6 nm | 0.7 nm |
| Example 4 | 103.5 nm | 103.1 nm | 0.7 nm |
| Example 5 | 100.3 nm | 99.4 nm | 0.9 nm |
| Example 6 | 100.3 nm | 98.8 nm | 1.5 nm |
| Comparative Example 1 | 103.4 nm | 98.1 nm | 5.3 nm |

In Examples 1 to 6, the change amount of the pattern size was smaller than that in Comparative Example 1 even when the underlayer film-coated wafer was stored for 48 hours. As a reason why the change amount of the pattern size was small in each of the examples, it is considered that blocking can be performed even when amine components are diffused from a base substrate having a SiON, SiN, or TiN film or the like. In addition, in each of the examples, it is considered that even when the underlayer film is left for several days after application, damage due to diffusion of the amine components is suppressed, thereby enabling the suppression of change in pattern size. Therefore, the resist underlayer film-forming composition of the present embodiment is expected to be a material that can be widely applied in application of a nitrogen atom-containing substrate for diversified semiconductor manufacturing processes.

## Claims

1. A resist underlayer film-forming composition for forming, in lithography using a photoresist film or an electron beam resist film, an underlayer film of the resist film on a nitrogen atom-containing substrate,
the resist underlayer film-forming composition comprising:
a polymer; and a crosslinking agent,
the polymer having a structural unit (A) having a polycyclic aromatic structure.

2. The resist underlayer film-forming composition according to claim 1, wherein the polymer has the polycyclic aromatic structure in a side chain of the polymer.

3. The resist underlayer film-forming composition according to claim 1, wherein the polycyclic aromatic structure is selected from naphthalene, anthracene, phenanthrene, pyrene, triphenylene, chrysene, naphthacene, biphenylene, fluorene, and carbazole, and may be substituted.

4. The resist underlayer film-forming composition according to claim 1, wherein the unit structure (A) is a unit structure represented by formula (A-1) below: 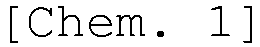 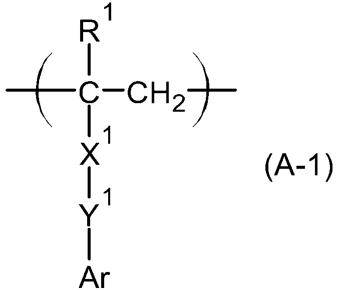 in formula (A-1), R¹ represents a hydrogen atom or a methyl group, X¹ represents a single bond, an ester group, or an amide group, Y¹ represents a single bond or an alkylene group having 1 to 6 carbon atoms, and Ar represents a monovalent group that is obtained by removing a hydrogen atom from naphthalene, anthracene, phenanthrene, pyrene, triphenylene, chrysene, naphthacene, biphenylene, fluorene, or carbazole and may be substituted.

5. The resist underlayer film-forming composition according to claim 1, wherein
the polymer further has a unit structure (B) having a reactive group, and
the crosslinking agent has a functional group capable of reacting with the reactive group.

6. The resist underlayer film-forming composition according to claim 5, wherein the unit structure (B) is at least one of a unit structure represented by formula (B-1) below and a unit structure represented by formula (B-2) below: 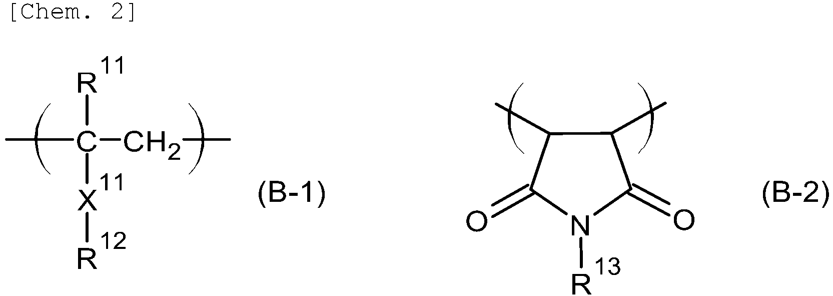 in formula (B-1), R¹¹ represents a hydrogen atom or a methyl group, X¹¹ represents an ester group or an amide group, and R¹² represents a monovalent group having 1 to 12 carbon atoms and having the reactive group, and in formula (B-2), R¹³ represents a monovalent group having 1 to 12 carbon atoms and having the reactive group.

7. The resist underlayer film-forming composition according to claim 1, wherein the polymer further has a unit structure (C) of at least one of a unit structure (C-1) having a monocyclic aromatic structure and a unit structure (C-2) derived from a maleimide structure.

8. The resist underlayer film-forming composition according to claim 7, wherein
the unit structure (C-1) is a unit structure represented by formula (C-1-1) below, and
the unit structure (C-2) is a unit structure represented by formula (C-2-1) below: 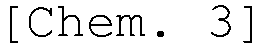 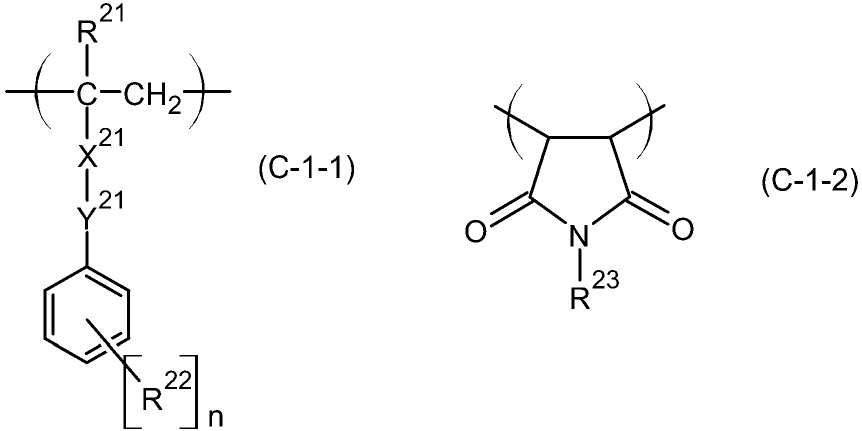
in formula (C-1-1), R²¹ represents a hydrogen atom or a methyl group, X²¹ represents a single bond, an ester group, or an amide group, Y²¹ represents a single bond or an alkylene group having 1 to 6 carbon atoms, R²² represents a halogen atom, an alkyl group that has 1 to 6 carbon atoms and may be substituted with a halogen atom, or an alkoxy group that has 1 to 6 carbon atoms and may be substituted with a halogen atom, n represents an integer of 0 to 5, and when there are two or more R²²'s, the two or more R²²'s may be identical or different, and
in formula (C-1-2), R²³ represents a hydrogen atom, an alkyl group that has 1 to 10 carbon atoms and may be substituted with a halogen atom, or an aryl group that has 6 to 10 carbon atoms and may be substituted with a halogen atom.

9. The resist underlayer film-forming composition according to claim 1, wherein a molar ratio of the unit structure (A) to all unit structures of the polymer is 40 mol% or more.

10. The resist underlayer film-forming composition according to claim 5, wherein a molar ratio of the unit structure (B) to all unit structures of the polymer is 5 mol% to 40 mol%.

11. The resist underlayer film-forming composition according to claim 1, wherein
the polymer further has a unit structure (B) having a reactive group, and a unit structure (C) of at least one of a unit structure (C-1) having a monocyclic aromatic structure and a unit structure (C-2) derived from a maleimide structure,
the crosslinking agent has a functional group capable of reacting with the reactive group,
the unit structure (A) is a unit structure represented by formula (A-1) below,
the unit structure (B) is at least one of a unit structure represented by formula (B-1) below and a unit structure represented by formula (B-2) below,
the unit structure (C-1) is a unit structure represented by formula (C-1-1) below,
the unit structure (C-2) is a unit structure represented by formula (C-2-1) below,
a molar ratio of the unit structure (A) to all unit structures of the polymer is 40 mol% or more, and
a molar ratio of the unit structure (B) to all unit structures of the polymer is 5 mol% to 40 mol%: 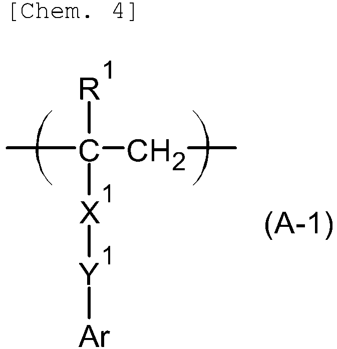
in formula (A-1), R¹ represents a hydrogen atom or a methyl group, X¹ represents a single bond, an ester group, or an amide group, Y¹ represents a single bond or an alkylene group having 1 to 6 carbon atoms, and Ar represents a monovalent group that is obtained by removing a hydrogen atom from naphthalene, anthracene, phenanthrene, pyrene, triphenylene, chrysene, naphthacene, biphenylene, fluorene, or carbazole and may be substituted, 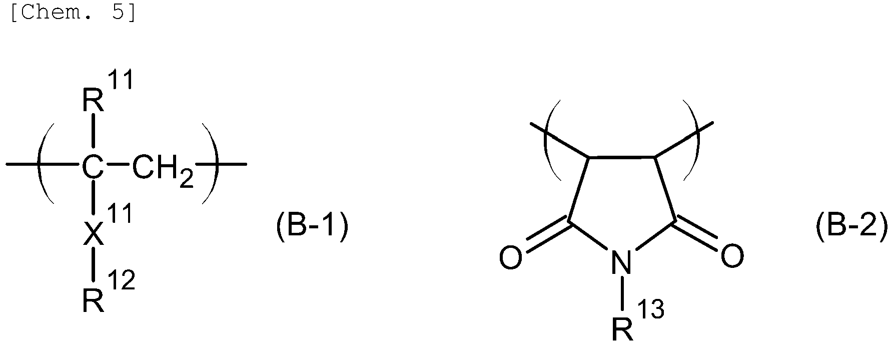
in formula (B-1), R¹¹ represents a hydrogen atom or a methyl group, X¹¹ represents an ester group or an amide group, and R¹² represents a monovalent group having 1 to 6 carbon atoms and having the reactive group, and
in formula (B-2), R¹³ represents a monovalent group having 1 to 6 carbon atoms and having the reactive group, 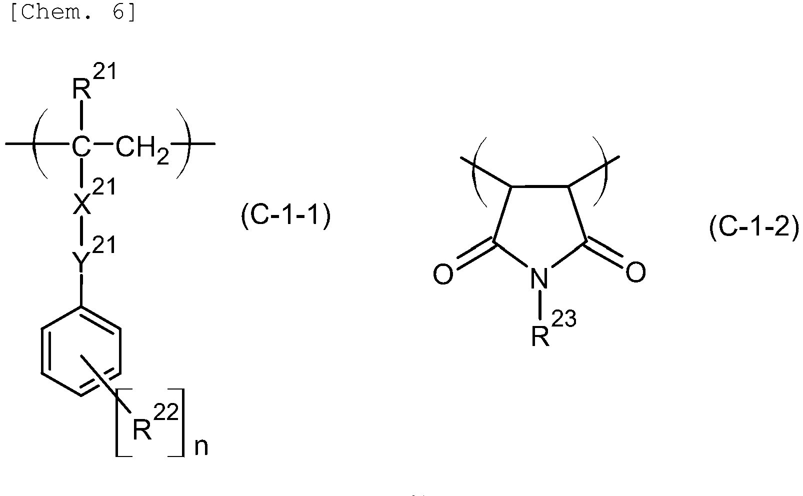
in formula (C-1-1), R²¹ represents a hydrogen atom or a methyl group, X²¹ represents a single bond, an ester group, or an amide group, Y²¹ represents a single bond or an alkylene group having 1 to 6 carbon atoms, R²² represents a halogen atom, an alkyl group that has 1 to 6 carbon atoms and may be substituted with a halogen atom, or an alkoxy group that has 1 to 6 carbon atoms and may be substituted with a halogen atom, n represents an integer of 0 to 5, and when there are two or more R²²'s, the two or more R²²'s may be identical or different, and
in formula (C-1-2), R²³ represents a hydrogen atom, an alkyl group that has 1 to 10 carbon atoms and may be substituted with a halogen atom, or an aryl group that has 6 to 10 carbon atoms and may be substituted with a halogen atom.

12. The resist underlayer film-forming composition according to claim 1, wherein a content of the crosslinking agent is 20 mass% to 50 mass% of the polymer.

13. An underlayer film formed on the nitrogen atom-containing substrate by using the resist underlayer film-forming composition according to any one of claims 1 to 12.

14. The underlayer film according to claim 13,
wherein a film thickness is less than 10 nm.

15. A method for producing a resist-patterned substrate, the method comprising steps of:
forming an underlayer film on the nitrogen atom-containing substrate using the resist underlayer film-forming composition according to any one of claims 1 to 12;
forming a resist film of either a photoresist film or an electron beam resist film on the underlayer film; and
irradiating the resist film with light or an electron beam, and then developing the resist film to obtain a resist pattern.

16. The method for producing a resist-patterned substrate according to claim 15, comprising a step of forming the resist film after 12 hours or more has elapsed following formation of the underlayer film.

17. A method for producing a semiconductor element, the method comprising steps of:
forming an underlayer film on the nitrogen atom-containing substrate using the resist underlayer film-forming composition according to any one of claims 1 to 12;
forming a resist film of either a photoresist film or an electron beam resist film on the underlayer film;
irradiating the resist film with light or an electron beam, and then developing the resist film to obtain a resist pattern; and
forming a patterned underlayer film by etching the underlayer film using the resist pattern as a mask.
